# EUROPEAN PATENT APPLICATION

(11) **EP 4 525 285 A1**
(43) Date of publication of application: **19.03.2025**
(21) Application number: 24199776.6
(22) Date of filing: 11.09.2024
(51) Int. Cl.: H02M 1/00, H02M 1/32, H02M 3/156, H02M 3/158, H02M 7/487, G01R 31/08

(54) **POWER GENERATION SYSTEM, INVERTER, AND SHORT-CIRCUIT DETECTION METHOD FOR NEGATIVE BRANCH OF INVERTER**

(30) Priority: 14.09.2023 CN 202311194402
(71) Applicant: Huawei Digital Power Technologies Co., Ltd., Shenzhen, Guangdong 518043 (CN)
(72) Inventor: Zhou, Xiaoxiang, Shenzhen, 518043 (CN); Gao, Yongbing, Shenzhen, 518043 (CN); Zheng, Shengnan, Shenzhen, 518043 (CN); Tang, Junsong, Shenzhen, 518043 (CN); Shi, Tao, Shenzhen, 518043 (CN)
(74) Representative: Epping - Hermann - Fischer

(57) **Abstract**

This application provides a power generation system, an inverter, and a short-circuit detection method for a negative branch of the inverter. The power generation system includes a plurality of photovoltaic modules, the inverter, and a transformer. The inverter includes a plurality of photovoltaic interfaces, a direct current conversion circuit, an inverter circuit, and a controller. A bridge arm middle point of at least one bridge arm in the inverter circuit is connected to a primary-side winding of the transformer, and is grounded through the transformer. Negative interfaces of the plurality of photovoltaic interfaces are connected to a negative input end of the direct current conversion circuit after being converged through a plurality of negative branches, and current sensors are disposed on some or all of the plurality of negative branches. The controller is configured to: locate, in response to that a current value on a loop formed by any negative branch and the direct current conversion circuit, a lower bridge arm switching transistor in the at least one bridge arm, and the transformer is greater than a preset current threshold, that a short-circuit to ground fault occurs on the any negative branch. According to this application, a faulty cable can be accurately located, ensuring reliable functioning of the inverter.

## Description

### TECHNICAL FIELD

This application relates to the field of power electronics technologies, and in particular, to a power generation system, an inverter, and a short-circuit detection method for a negative branch of the inverter.

### BACKGROUND

As power supported by a photovoltaic inverter increases, a quantity of connected photovoltaic strings also increases. Due to reasons such as non-standard construction or friction between a cable and a cable support, a cable sheath of a photovoltaic string cable may be damaged, causing a short-circuit to ground fault of the photovoltaic string cable. Provided that the photovoltaic string cable is short-circuited to the ground, the photovoltaic inverter fails due to overcurrent. If the fault is not rectified, the photovoltaic inverter fails again after the photovoltaic inverter is replaced. There are a large quantity of photovoltaic-side cables and modules, photovoltaic string cables may be short-circuited to the ground transiently, and a short circuit status disappears and occurs repeatedly (for example, the photovoltaic string cables are repeatedly short-circuited due to wind blowing and cable support scraping). As a result, it is difficult to quickly locate a specific fault point. Currently, there is no better method to locate and troubleshoot the photovoltaic string cable, and the photovoltaic inverter still fails after the photovoltaic inverter is frequently replaced at a same location. Therefore, it is quite important to correctly locate the photovoltaic string cable that is short-circuited to the ground and replace the photovoltaic string cable with a new photovoltaic string cable or battery panel to rectify the fault of the photovoltaic inverter at the same location, so that greater property and power generation losses can be avoided.

### SUMMARY

Embodiments of this application provide a power generation system, an inverter, and a short-circuit detection method for a negative branch of an inverter, so that a faulty cable can be accurately located, ensuring reliable functioning of the inverter.

According to a first aspect, this application provides a power generation system. The power generation system includes a plurality of photovoltaic modules, an inverter, and a transformer, the inverter includes a plurality of photovoltaic interfaces, a direct current conversion circuit, an inverter circuit, and a controller, each photovoltaic interface is configured to be connected to one photovoltaic module, the inverter circuit includes at least one bridge arm and a bus capacitor, a positive output end and a negative output end of the direct current conversion circuit are respectively connected to two ends of the bus capacitor, a bridge arm middle point of the at least one bridge arm is connected to a primary-side winding of the transformer as an output end of the inverter, and is grounded through the transformer, the bridge arm includes at least one lower bridge arm switching transistor, and a direction of a current flowing through the at least one lower bridge arm switching transistor is from the bus capacitor to the bridge arm middle point when the at least one lower bridge arm switching transistor is turned off. The plurality of photovoltaic interfaces include positive interfaces and negative interfaces, the positive interfaces of the plurality of photovoltaic interfaces are connected to a positive input end of the direct current conversion circuit after being converged through a plurality of positive branches, the negative interfaces of the plurality of photovoltaic interfaces are connected to a negative input end of the direct current conversion circuit after being converged through a plurality of negative branches, and current sensors are disposed on some or all of the plurality of negative branches. Herein, the controller may locate, in response to that a current value on a current loop formed by any negative branch of the plurality of negative branches and the direct current conversion circuit, the lower bridge arm switching transistor in the at least one bridge arm, and the transformer is greater than a preset current threshold, that a short-circuit to ground fault occurs on the any negative branch, and send short-circuit fault information that includes a location of the any negative branch.

In this application, on the negative branches corresponding to the negative interfaces of the plurality of photovoltaic interfaces of the inverter, the current sensors may be disposed on some or all of the negative branches. Herein, the current sensor may be disposed on the negative branch inside the inverter. The controller in the foregoing inverter may obtain a current value of any negative branch based on a current value obtained by each current sensor, and the controller may determine, in response to that the current value of the any negative branch is greater than the preset current threshold, that the any negative branch is short-circuited. The controller can generate an alarm prompt for one or more negative branches that are short-circuited, facilitating repair or replacement of the faulty negative branch, so that the faulty negative branch is located quickly and accurately, to avoid overcurrent caused because a faulty photovoltaic string cable is short-circuited to the ground inside the inverter. This ensures reliable functioning of the inverter and improves power supply efficiency to the load.

In a possible implementation, the plurality of negative branches are sequentially connected to a negative bus, and connected to the negative input end of the direct current conversion circuit through the negative bus. The plurality of negative branches include a first negative branch, one branch current sensor is disposed on the first negative branch, the branch current sensor is located between a negative interface corresponding to the first negative branch and the negative bus, and the branch current sensor is configured to measure current information of the first negative branch, and upload the current information of the first negative branch to the controller. The plurality of negative branches include a second negative branch, a combination current sensor is disposed at a connection end between the second negative branch and the negative bus, the second negative branch is located on the negative bus, and the combination current sensor is configured to measure current information of the connection end between the second negative branch and the negative bus, and upload the current information of the connection end between the second negative branch and the negative bus to the controller. The branch current sensors are disposed on some of the negative branches, and the combination current sensor is disposed on the negative bus, so that the current value of the any negative branch is obtained based on the current information uploaded by the branch current sensor and the combination current sensor, the current of the negative branch is easily obtained, and applicability is high.

In a possible implementation, the controller is configured to: obtain a current value of the first negative branch based on the current information that is obtained by the branch current sensor disposed on the first negative branch; and obtain, based on the current information that is obtained by the combination current sensor corresponding to the second negative branch, a sum of a current value of the second negative branch and current values of negative branches before the second negative branch, and subtract a sum of the current values of the negative branches before the second negative branch from the sum of the current values to obtain the current value of the second negative branch. The branch current sensors are disposed on some of the negative branches, and the combination current sensor is disposed on the negative bus, so that the current value of the any negative branch is obtained based on the current information uploaded by the branch current sensor and the combination current sensor, the current of the negative branch is easily obtained, and applicability is high.

In a possible implementation, the inverter includes N photovoltaic interfaces, N negative branches corresponding to the N photovoltaic interfaces include N-1 first negative branches and one second negative branch, and one combination current sensor is disposed between the negative input end of the direct current conversion circuit and a connection end between the second negative branch and the negative bus; and the controller is configured to: obtain current values of the N-1 first negative branches based on current information obtained by branch current sensors disposed on the N-1 first negative branches; and obtain a sum of current values of the N negative branches based on current information obtained by the combination current sensor, and subtract a sum of the current values of the N-1 first negative branches from the sum of the current values of the N negative branches to obtain a current value of the second negative branch. The controller generates an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load.

In a possible implementation, one branch current sensor is disposed on each of the plurality of negative branches; and the branch current sensor is configured to: measure current information of a branch on which the branch current sensor is located, and upload the current information of the branch to the controller. The branch current sensors are disposed on all of the negative branches, and the current value of the any negative branch is obtained based on the branch current sensor, so that the current of the negative branch is easily obtained, and applicability is high.

In a possible implementation, the inverter includes a first photovoltaic interface and a second photovoltaic interface, one branch current difference sensor is disposed on a negative branch corresponding to a negative interface of the first photovoltaic interface, a negative branch corresponding to a negative interface of the second photovoltaic interface is connected, through the branch current difference sensor, to the negative branch corresponding to the negative interface of the first photovoltaic interface, and a connection end between the negative branches corresponding to the negative interfaces of the first photovoltaic interface and the second photovoltaic interface is connected to the negative input end of the direct current conversion circuit through one combination current sensor; and the branch current difference sensor is configured to: measure a difference between currents of the negative branches corresponding to the negative interfaces of the first photovoltaic interface and the second photovoltaic interface, and upload the difference between the currents to the controller, and the combination current sensor is configured to measure: a sum of current values of the negative branches corresponding to the negative interfaces of the first photovoltaic interface and the second photovoltaic interface, and upload the sum of the current values to the controller. The controller generates an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load.

In a possible implementation, the inverter circuit includes a positive bus capacitor and a negative bus capacitor that are connected in series, the bridge arm includes one lower bridge arm switching transistor, one end of the lower bridge arm switching transistor is connected to a positive electrode of one diode and connected to the negative bus capacitor, and the other end of the lower bridge arm switching transistor is connected to a negative electrode of the diode and connected to the bridge arm middle point.

In a possible implementation, the inverter circuit includes a positive bus capacitor and a negative bus capacitor that are connected in series, the bridge arm includes a first lower bridge arm switching transistor and a second lower bridge arm switching transistor that are connected in series, one end of the first lower bridge arm switching transistor is connected to a positive electrode of a first diode and connected to the negative bus capacitor, the other end of the first lower bridge arm switching transistor is connected to a negative electrode of the first diode, one end of the second lower bridge arm switching transistor is connected to a positive electrode of a second diode, and the other end of the second lower bridge arm switching transistor is connected to a negative electrode of the second diode and connected to the bridge arm middle point.

In a possible implementation, the inverter includes a voltage detection circuit, and the voltage detection circuit is configured to obtain a negative photovoltaic voltage value at the negative input end of the direct current conversion circuit; and the controller is configured to: locate, in response to that the negative photovoltaic voltage value is greater than a voltage threshold and a current value of the any negative branch is greater than the preset current threshold, that the short-circuit fault occurs on the any negative branch, and send the short-circuit fault information that includes the location of the any negative branch. Herein, when detecting that the negative photovoltaic voltage value is greater than the voltage threshold, the controller determines that negative branches corresponding to some of the plurality of photovoltaic ports are short-circuited to the ground, and then locates, based on a current value of each negative branch, a negative branch that is short-circuited. In this way, misjudgment of the faulty negative branch can be reduced, and accuracy of locating the faulty cable is further improved.

In a possible implementation, the inverter includes a leakage current detection circuit, and the leakage current detection circuit is configured to obtain a difference between currents at any two phases of output ends of three phases of output ends of the inverter circuit; and the controller is configured to: locate, in response to that the difference between the currents of the any two phases of output ends of the three phases of output ends of the inverter circuit is greater than a specified threshold and a current value of the any negative branch is greater than the preset current threshold, that the short-circuit fault occurs on the any negative branch, and send the short-circuit fault information that includes the location of the any negative branch. Herein, when detecting that the negative photovoltaic voltage value is greater than the voltage threshold and the difference between the currents of the any two phases of output ends of the three phases of output ends is greater than the specified threshold, the controller determines that the negative branches corresponding to some of the plurality of photovoltaic ports are short-circuited to the ground, and then locates, based on a current value of each negative branch, a negative branch that is short-circuited. In this way, misjudgment of the faulty negative branch can be reduced, and accuracy of locating the faulty cable is further improved.

In a possible implementation, the inverter includes an inverter output sampling circuit, and the inverter output sampling circuit is configured to obtain currents at three phases of output ends of the inverter circuit; and the controller is configured to: locate, in response to that a difference between currents at any two phases of output ends of the three phases of output ends of the inverter circuit is greater than a specified threshold and a current value of the any negative branch is greater than the preset current threshold, that the short-circuit fault occurs on the any negative branch, and send the short-circuit fault information that includes the location of the any negative branch. Herein, when detecting that the negative photovoltaic voltage value is greater than the voltage threshold and the difference between the currents of the any two phases of output ends of the three phases of output ends is greater than the specified threshold, the controller determines that the negative branches corresponding to some of the plurality of photovoltaic ports are short-circuited to the ground, and then locates, based on a current value of each negative branch, a negative branch that is short-circuited. In this way, misjudgment of the faulty negative branch can be reduced, and accuracy of locating the faulty cable is further improved.

According to a second aspect, this application provides an inverter. The inverter includes a plurality of photovoltaic interfaces, a direct current conversion circuit, an inverter circuit, and a controller, the inverter circuit includes at least one bridge arm and a bus capacitor, a positive output end and a negative output end of the direct current conversion circuit are respectively connected to two ends of the bus capacitor, a bridge arm middle point of the at least one bridge arm is connected to a primary-side winding of a transformer as an output end of the inverter, and is grounded through the transformer, the bridge arm includes at least one lower bridge arm switching transistor, and a direction of a current flowing through the at least one lower bridge arm switching transistor is from the bus capacitor to the bridge arm middle point when the at least one lower bridge arm switching transistor is turned off. The plurality of photovoltaic interfaces include positive interfaces and negative interfaces, the positive interfaces of the plurality of photovoltaic interfaces are connected to a positive input end of the direct current conversion circuit after being converged through a plurality of positive branches, the negative interfaces of the plurality of photovoltaic interfaces are connected to a negative input end of the direct current conversion circuit after being converged through a plurality of negative branches, and current sensors are disposed on some or all of the plurality of negative branches. The controller is configured to: locate, in response to that a current value of any negative branch of the plurality of negative branches is greater than a preset current threshold, that a short-circuit to ground fault occurs on the any negative branch, and send short-circuit fault information that includes a location of the any negative branch. The controller can generate an alarm prompt for one or more negative branches that are short-circuited, facilitating repair or replacement of the faulty negative branch, so that the faulty negative branch is located quickly and accurately, to avoid overcurrent caused because a faulty photovoltaic string cable is short-circuited to the ground inside the inverter. This ensures reliable functioning of the inverter and improves power supply efficiency to the load.

In a possible implementation, the plurality of negative branches are sequentially connected to a negative bus, and connected to the negative input end of the direct current conversion circuit through the negative bus. The plurality of negative branches include a first negative branch, one branch current sensor is disposed on the first negative branch, the branch current sensor is located between a negative interface corresponding to the first negative branch and the negative bus, and the branch current sensor is configured to measure current information of the first negative branch, and upload the current information of the first negative branch to the controller. The plurality of negative branches include a second negative branch, a combination current sensor is disposed at a connection end between the second negative branch and the negative bus, the second negative branch is located on the negative bus, and the combination current sensor is configured to measure current information of the connection end between the second negative branch and the negative bus, and upload the current information of the connection end between the second negative branch and the negative bus to the controller. Branch current sensors are disposed on some of the negative branches, and the combination current sensor is disposed on the negative bus, so that a current value of the any negative branch is obtained based on the current information uploaded by the branch current sensor and the combination current sensor, the current of the negative branch is easily obtained, and applicability is high.

In a possible implementation, the controller is configured to: obtain a current value of the first negative branch based on the current information that is obtained by the branch current sensor disposed on the first negative branch; and obtain, based on the current information that is obtained by the combination current sensor corresponding to the second negative branch, a sum of a current value of the second negative branch and current values of negative branches before the second negative branch, and subtract a sum of the current values of the negative branches before the second negative branch from the sum of the current values to obtain the current value of the second negative branch. The branch current sensors are disposed on some of the negative branches, and the combination current sensor is disposed on the negative bus, so that the current value of the any negative branch is obtained based on the current information uploaded by the branch current sensor and the combination current sensor, the current of the negative branch is easily obtained, and applicability is high.

In a possible implementation, the inverter includes N photovoltaic interfaces, N negative branches corresponding to the N photovoltaic interfaces include N-1 first negative branches and one second negative branch, and one combination current sensor is disposed between the negative input end of the direct current conversion circuit and a connection end between the second negative branch and the negative bus; and the controller is configured to: obtain current values of the N-1 first negative branches based on current information obtained by branch current sensors disposed on the N-1 first negative branches; and obtain a sum of current values of the N negative branches based on current information obtained by the combination current sensor, and subtract a sum of the current values of the N-1 first negative branches from the sum of the current values of the N negative branches to obtain a current value of the second negative branch. The controller generates an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load.

In a possible implementation, one branch current sensor is disposed on each of the plurality of negative branches; and the branch current sensor is configured to: measure current information of a branch on which the branch current sensor is located, and upload the current information of the branch to the controller. The branch current sensors are disposed on all of the negative branches, and the current value of the any negative branch is obtained based on the branch current sensor, so that the current of the negative branch is easily obtained, and applicability is high.

In a possible implementation, the inverter includes a first photovoltaic interface and a second photovoltaic interface, one branch current difference sensor is disposed on a negative branch corresponding to a negative interface of the first photovoltaic interface, a negative branch corresponding to a negative interface of the second photovoltaic interface is connected, through the branch current difference sensor, to the negative branch corresponding to the negative interface of the first photovoltaic interface, and a connection end between the negative branches corresponding to the negative interfaces of the first photovoltaic interface and the second photovoltaic interface is connected to the negative input end of the direct current conversion circuit through one combination current sensor; and the branch current difference sensor is configured to: measure a difference between currents of the negative branches corresponding to the negative interfaces of the first photovoltaic interface and the second photovoltaic interface, and upload the difference between the currents to the controller, and the combination current sensor is configured to measure: a sum of current values of the negative branches corresponding to the negative interfaces of the first photovoltaic interface and the second photovoltaic interface, and upload the sum of the current values to the controller. The controller generates an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load.

According to a third aspect, this application provides a short-circuit detection method for a negative branch of an inverter. The method includes: locating, in response to that a current value of any negative branch of a plurality of negative branches is greater than a preset current threshold, that a short-circuit fault occurs on the any negative branch, and sending short-circuit fault information that includes a location of the any negative branch, where positive interfaces of a plurality of photovoltaic interfaces in the inverter are connected to a positive input end of a direct current conversion circuit after being converged through a plurality of positive branches, negative interfaces of the plurality of photovoltaic interfaces are connected to a negative input end of the direct current conversion circuit after being converged through the plurality of negative branches, and current sensors are disposed on some or all of the plurality of negative branches.

In this application, the inverter may obtain, through a controller based on a current value obtained by each current sensor, the current value of the any negative branch, and may determine, in response to that the current value of the any negative branch is greater than the preset current threshold, that the any negative branch is short-circuited. The current sensor is disposed on the negative branch inside the inverter, and the current value of the any negative branch connected to the direct current conversion circuit is obtained through the controller, to locate, based on the current value of the any negative branch, the negative branch that is short-circuited. The controller can generate an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load.

### BRIEF DESCRIPTION OF DRAWINGS

FIG. 1 is a diagram of an application scenario of a power generation system according to this application;
FIG. 2 is a diagram of a structure of a power generation system according to this application;
FIG. 3 is a diagram of another structure of a power generation system according to this application;
FIG. 4 is a diagram of another structure of a power generation system according to this application;
FIG. 5 is a diagram of another structure of a power generation system according to this application;
FIG. 6 is a diagram of another structure of an inverter according to this application;
FIG. 7 is a diagram of another structure of an inverter according to this application;
FIG. 8 is a diagram of another structure of an inverter according to this application;
FIG. 9 is a diagram of another structure of an inverter according to this application;
FIG. 10 is a diagram of another structure of an inverter according to this application;
FIG. 11 is a diagram of another structure of an inverter according to this application;
FIG. 12 is a diagram of another structure of an inverter according to this application;
FIG. 13 is a diagram of another structure of an inverter according to this application;
FIG. 14 is a diagram of another structure of an inverter according to this application;
FIG. 15 is a diagram of another structure of an inverter according to this application;
FIG. 16 is a diagram of another structure of an inverter according to this application; and
FIG. 17 is a schematic flowchart of a short-circuit detection method for a negative branch of an inverter according to this application.

### DESCRIPTION OF EMBODIMENTS

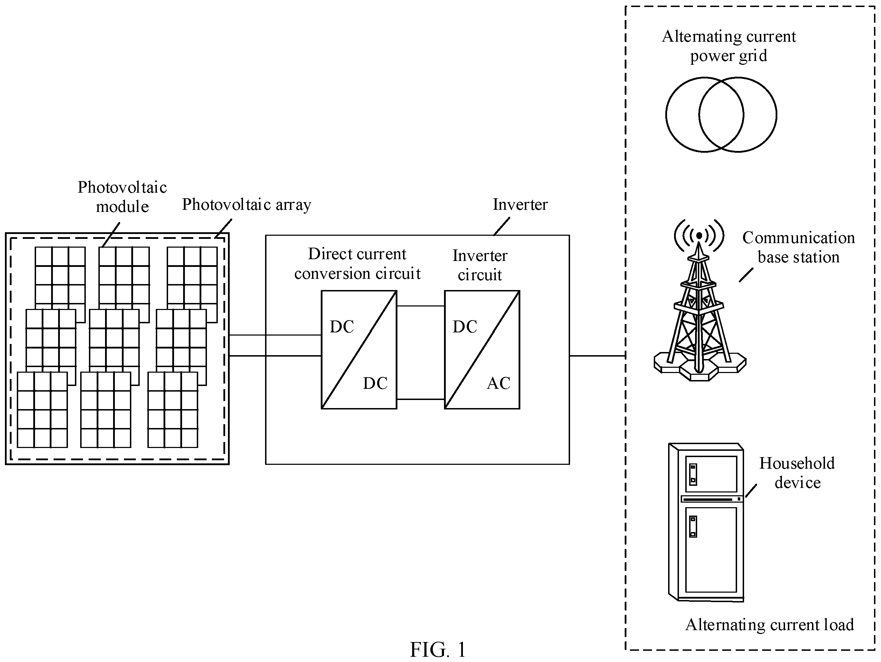

FIG. 1 is a diagram of an application scenario of a power generation system according to this application. The power generation system provided in this application may include a direct current power supply and an inverter. The direct current power supply may include a photovoltaic array. An output end of the photovoltaic array may be connected to a first end of the inverter, and a second end of the inverter is connected to an alternating current load. In the power generation system shown in FIG. 1, the photovoltaic array may include one or more photovoltaic strings connected in series or in parallel, and one photovoltaic string may be obtained by connecting one or more photovoltaic modules in series. The inverter may change (which may boost, buck, or the like), through a direct current conversion circuit, a direct current provided by the photovoltaic array, and supply power to the alternating current load after performing voltage inversion conversion on the converted direct current through an inverter circuit. The alternating current load may be an alternating current power grid or an alternating current electric device. Herein, when the inverter is grid-connected, the alternating current load may be the alternating current power grid. When the inverter is off-grid, the alternating current load may be the alternating current electric device.

In the application scenario shown in FIG. 1, the inverter may include a plurality of photovoltaic interfaces to be connected to the plurality of photovoltaic strings, and a quantity of connected photovoltaic strings is directly proportional to power supported by the inverter. For example, an inverter in an industrial power generation system may include a large quantity of photovoltaic interfaces, to be configured to be connected to a large quantity of photovoltaic modules. The inverter can be connected to each photovoltaic string through a photovoltaic string cable. In a power supply process of each photovoltaic string, due to reasons such as non-standard construction or friction between a cable and a cable support, a sheath of the photovoltaic string cable may be damaged, causing a short-circuit to ground fault of the photovoltaic string cable. In addition, because the photovoltaic string cable is short-circuited to the ground, the inverter fails due to overcurrent, affecting normal functioning of the inverter. There are a large quantity of photovoltaic-side cables and modules, photovoltaic string cables may be short-circuited to the ground transiently, and a short-circuit status may occur repeatedly (for example, the photovoltaic string cables are repeatedly short-circuited due to wind blowing and cable support scraping). Therefore, when the photovoltaic string cable is short-circuited to the ground, it is quite important to quickly locate a faulty photovoltaic string cable in a timely manner to rectify the fault, to ensure normal running of the power generation system. The photovoltaic string cable may include a negative branch and a positive branch, that is, each photovoltaic string may be connected to a photovoltaic interface of the inverter through the negative branch and the positive branch. Currently, there is no effective solution to a short-circuit fault of the negative branch. When a short-circuit to ground fault occurs on the negative branch (that is, due to accidental grounding), overcurrent is caused inside the inverter, which affects normal functioning of the inverter and reduces power supply efficiency to the load.

In the power generation system provided in this application, the inverter may include a plurality of photovoltaic interfaces, and the photovoltaic interface of the inverter may be connected to the photovoltaic string through the negative branch and the positive branch. Specifically, the photovoltaic interface includes a positive interface and a negative interface, positive interfaces of the plurality of photovoltaic interfaces are connected to a positive input end of the direct current conversion circuit after being converged through positive branches corresponding to the positive interfaces, negative interfaces of the plurality of photovoltaic interfaces are connected to a negative input end of the direct current conversion circuit after being converged through negative branches corresponding to the negative interfaces, and an output end of the direct current conversion circuit is connected to the inverter circuit. On the negative branches corresponding to the negative interfaces of the plurality of photovoltaic interfaces, current sensors (not shown in FIG. 1) may be disposed on some or all of the negative branches. Herein, the current sensor may be disposed on the negative branch inside the inverter. The inverter may include a controller. The controller may obtain a current value of any negative branch based on a current value obtained by each current sensor, and the controller may determine, in response to that the current value of the any negative branch is greater than a preset current threshold, that the any negative branch is short-circuited. The controller can generate an alarm prompt for one or more negative branches that are short-circuited, facilitating repair or replacement of the faulty negative branch, so that the faulty negative branch is located quickly and accurately, to avoid overcurrent caused because a faulty photovoltaic string cable is short-circuited to the ground inside the inverter. This ensures reliable functioning of the inverter and improves power supply efficiency to the load.

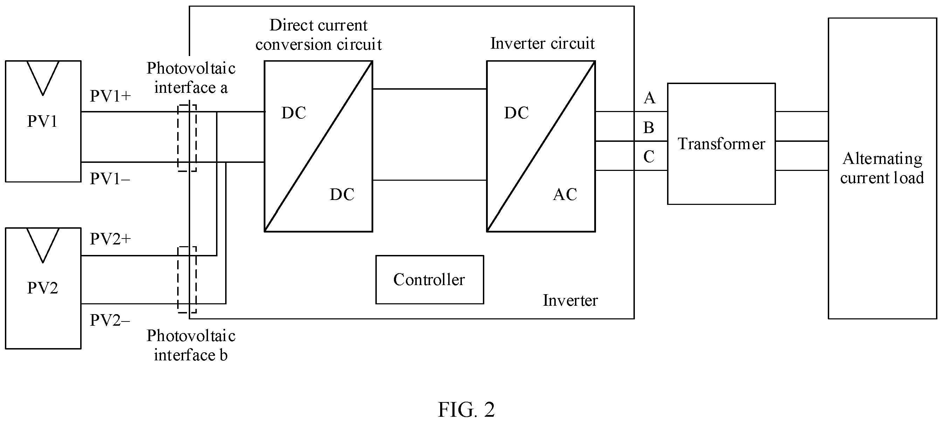

FIG. 2 is a diagram of a structure of a power generation system according to this application. The power generation system shown in FIG. 2 may include a direct current power supply, an inverter, and a transformer. The direct current power supply may be a photovoltaic array that includes a plurality of photovoltaic strings. Bridge arms (not shown in FIG. 2) in an inverter circuit may be connected to a phase-A port, a phase-B port, and a phase-C port, and the phase-A port, the phase-B port, and the phase-C port may be connected to a primary-side winding of the transformer, to be connected to an alternating current load through the transformer. For example, the inverter includes two photovoltaic interfaces (which may be represented as a photovoltaic interface a and a photovoltaic interface b for ease of description). A positive branch PV1+ and a negative branch PV1- that correspond to a positive interface and a negative interface of the photovoltaic interface a are each connected to a photovoltaic string PV1. A photovoltaic string PV2 is connected to each of a positive interface and a negative interface of the photovoltaic interface b through a corresponding positive branch PV2+ and a corresponding negative branch PV2-. After being connected to each other, the positive branches corresponding to the photovoltaic interface a and the photovoltaic interface b may be connected to a positive input end of the direct current conversion circuit in the inverter. After being connected to each other, the negative branches corresponding to the photovoltaic interface a and the photovoltaic interface b may be connected to a negative input end of the direct current conversion circuit. An output end of the direct current conversion circuit is connected to the inverter circuit. The inverter may change (which may boost, buck, or the like), through the direct current conversion circuit, a direct current provided by the photovoltaic array, and may output an alternating current to the transformer after performing voltage inversion conversion on the converted direct current through the inverter circuit. The transformer performs voltage conversion on the alternating current provided by the inverter, and then supplies power to the alternating current load.

In some feasible implementations, in the power generation system shown in FIG. 2, current sensors (not shown in FIG. 2) may be disposed on some or all of the negative branches. Specifically, the current sensor may be disposed on the negative branch inside the inverter. The inverter may include a controller. The controller may obtain current values of the negative branch PV1- and the negative branch PV2- based on current values obtained by the current sensors, and the controller may determine, in response to that a current value of any negative branch is greater than a preset current threshold, or in response to that a current value of a current loop formed by any negative branch, the direct current conversion circuit, a lower bridge arm switching transistor (not shown in FIG. 2) in the inverter circuit, and the transformer is greater than a preset current threshold, that the any negative branch is short-circuited. The current sensor is disposed on the negative branch inside the inverter, and the current value of the any negative branch connected to the direct current conversion circuit is obtained through the controller, to locate, based on the current value of the any negative branch, the negative branch that is short-circuited. For example, if it is detected that a current value of the negative branch PV1- is greater than the preset current threshold, it is determined that the negative branch PV1- is short-circuited to the ground. The controller can generate an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load.

In some feasible implementations, the controller may locate, in response to that the current value of the any negative branch of the plurality of negative branches is greater than the preset current threshold, that a short-circuit fault occurs on the any negative branch, and send short-circuit fault information that includes a location of the faulty negative branch. Specifically, the controller may send, to an independent communication apparatus (for example, a mobile phone or another portable communication device), the short-circuit fault information that includes the location of the faulty negative branch, so that the communication apparatus prompts, by using an image, a sound, or the like, the negative branch on which the short-circuit fault occurs. Alternatively, the controller may send, to an alarm device installed in the power generation system, the short-circuit fault information that includes the location of the faulty negative branch, so that the alarm device prompts, by using an image, a sound, or the like, the negative branch on which the short-circuit fault occurs. This may be specifically determined based on an actual application scenario requirement, and is not limited herein.

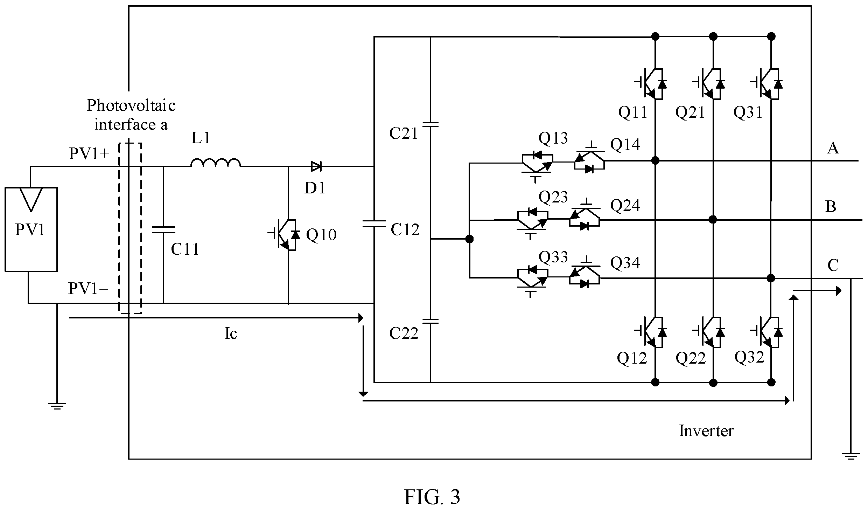

FIG. 3 is a diagram of another structure of a power generation system according to this application. As shown in FIG. 3, an inverter in FIG. 3 includes a direct current conversion circuit and an inverter circuit. The direct current conversion circuit may include a capacitor C11 and a capacitor C 12. The capacitor C11 is connected in parallel to two ends of an inductor L1 and a switching transistor Q10 that are connected in series, one end of the capacitor C12 is connected to one end of the switching transistor Q10 through a diode D1, and the other end of the capacitor C12 is connected to the other end of the switching transistor Q10. The inverter circuit may include a capacitor C21, a capacitor C22, and three bridge arms (a bridge arm a, a bridge arm b, and a bridge arm c). The capacitor C21 and the capacitor C22 are connected in series and then connected in parallel to the two ends of the capacitor C12, bridge arm middle points of the bridge arm a, the bridge arm b, and the bridge arm c are respectively connected to a phase-A port, a phase-B port, and a phase-C port of the inverter, and the phase-A port, the phase-B port, and the phase-C port of the inverter may be connected to a primary-side winding of a transformer, and is grounded through the transformer. The bridge arm a may include a switching transistor Q11 and a switching transistor Q12 that are connected in series. The switching transistor Q11 and the switching transistor Q12 may be connected in parallel to two ends of the capacitor C21 and the capacitor C22 that are connected in series. The switching transistor Q12 is a lower bridge arm switching transistor of the bridge arm a, one end of the switching transistor Q12 is connected to a positive electrode of one diode and connected to the capacitor C22, and the other end of the switching transistor Q12 is connected to a negative electrode of the diode and connected to the bridge arm middle point (a connection end between the switching transistor Q11 and the switching transistor Q12) of the bridge arm a. The connection end between the switching transistor Q11 and the switching transistor Q12 may be connected to the phase-A port, and the connection end between the switching transistor Q11 and the switching transistor Q12 may be connected to a connection end between the capacitor C21 and the capacitor C22 through another switching transistor Q13 and another switching transistor Q14 that are connected in series. The bridge arm b may include a switching transistor Q21, a switching transistor Q22, a switching transistor Q23, and a switching transistor Q24, and the bridge arm c may include a switching transistor Q31, a switching transistor Q32, a switching transistor Q33, and a switching transistor Q34. It may be understood that circuit structures of the bridge arm b and the bridge arm c are the same as the circuit structure of the bridge arm a. Details are not described herein again. Each switching transistor in the inverter may be a metal-oxide-semiconductor field-effect transistor (Metal-Oxide-Semiconductor Field-Effect Transistor, MOSFET), which is a MOS transistor for short, or may be an insulated gate bipolar transistor (insulated gate bipolar transistor, IGBT) or the like. This is not limited herein. A photovoltaic interface of the inverter may be connected to a photovoltaic string through a negative branch and a positive branch. For example, a positive branch PV1+ and a negative branch PV1- that correspond to a photovoltaic string PV1 are connected to a photovoltaic interface a of the inverter. In a power supply process of the photovoltaic string, due to reasons such as non-standard construction or friction between a cable and a cable support, a cable sheath of a photovoltaic string cable may be damaged, causing a short-circuit to ground fault of the photovoltaic string cable. When the short-circuit to ground fault occurs, overcurrent may occur in the inverter, that is, a current higher than a rated current value occurs in the inverter. The overcurrent may damage a power component in the inverter. For example, the short-circuit to ground fault occurs on the negative branch PV1- corresponding to the photovoltaic string PV1, and a current Ic higher than a preset current threshold occurs on a current loop formed by the negative branch PV1- and the direct current conversion circuit, a lower bridge arm switching transistor in each bridge arm, and the transformer. The current Ic may flow to the bridge arm in the inverter circuit through the direct current conversion circuit, and damage the switching transistor included in the bridge arm. For example, the current Ic may flow to a lower bridge arm switching transistor (namely, the switching transistor Q32) in the bridge arm c through the direct current conversion circuit, and flow to the transformer through the phase-C port of the inverter. Herein, the lower bridge arm switching transistors of the bridge arm a, the bridge arm b, and the bridge arm c may be damaged because the lower bridge arm switching transistors cannot bear the current Ic, thereby affecting normal functioning of the inverter. It may be understood that the direct current conversion circuit may be of another circuit type having a direct current conversion function, and the inverter circuit may alternatively be of another circuit type having an inverter function. This may be specifically determined based on an actual application scenario requirement, and is not limited herein.

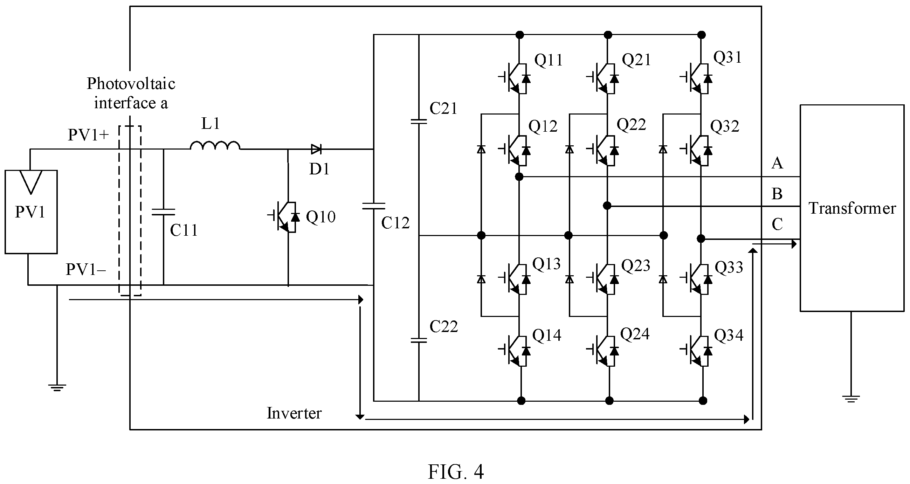

FIG. 4 is a diagram of another structure of a power generation system according to this application. As shown in FIG. 4, an inverter in FIG. 4 includes a direct current conversion circuit and an inverter circuit. The direct current conversion circuit may include a capacitor C11 and a capacitor C12. The capacitor C11 is connected in parallel to two ends of an inductor L1 and a switching transistor Q 10 that are connected in series, one end of the capacitor C12 is connected to one end of the switching transistor Q10 through a diode D1, and the other end of the capacitor C12 is connected to the other end of the switching transistor Q10. The inverter circuit may include a capacitor C21, a capacitor C22, and three bridge arms (a bridge arm a, a bridge arm b, and a bridge arm c). The capacitor C21 and the capacitor C22 are connected in series and then connected in parallel to the two ends of the capacitor C12, bridge arm middle points of the bridge arm a, the bridge arm b, and the bridge arm c are respectively connected to a phase-A port, a phase-B port, and a phase-C port of the inverter, and the phase-A port, the phase-B port, and the phase-C port of the inverter may be connected to a primary-side winding of a transformer, and is grounded through the transformer. The bridge arm a may include four bridge arm switching transistors (which, for ease of description, may be represented as a switching transistor Q11, a switching transistor Q12, a switching transistor Q13, and a switching transistor Q14) connected in series, the switching transistor Q11, the switching transistor Q12, the switching transistor Q13, and the switching transistor Q14 are sequentially connected in series and connected in parallel to two ends of the capacitor C21 and the capacitor C22. The switching transistor Q13 and the switching transistor Q14 are lower bridge arm switching transistors of the bridge arm a, two ends of the switching transistor Q14 are connected in parallel to one diode, a positive electrode of the diode is connected to the capacitor C22, two ends of the switching transistor Q13 are connected in parallel to another diode, and a negative electrode of the diode is connected to a bridge arm middle point (a connection end between the switching transistor Q12 and the switching transistor Q13) of the bridge arm a. A connection end between the switching transistor Q11 and the switching transistor Q12 is connected to a connection end between the switching transistor Q13 and the switching transistor Q14 through two diodes connected in series, and a connection end between the two diodes connected in series is connected to a connection end between the capacitor C21 and the capacitor C22. The bridge arm middle point of the bridge arm a, namely, the connection end between the switching transistor Q12 and the switching transistor Q13, may be connected to the phase-A port. The bridge arm b may include a switching transistor Q21, a switching transistor Q22, a switching transistor Q23, a switching transistor Q24, and two diodes, and the bridge arm c may include a switching transistor Q31, a switching transistor Q32, a switching transistor Q33, a switching transistor Q34, and two diodes. It may be understood that circuit structures of the bridge arm b and the bridge arm c are the same as the circuit structure of the bridge arm a. Details are not described herein again. When a short-circuit to ground fault occurs on a negative branch PV1-corresponding to a photovoltaic string PV1, and a current Ic higher than a preset current threshold occurs on a current loop formed by the negative branch PV1- and the direct current conversion circuit, a lower bridge arm switching transistor in each bridge arm, and the transformer. The current Ic may flow to the bridge arm in the inverter circuit through the direct current conversion circuit, and damage the switching transistor included in the bridge arm. For example, the current Ic may flow to a lower bridge arm switching transistor (namely, the switching transistor Q32) in the bridge arm c through the direct current conversion circuit, and flow to the transformer through the phase-C port of the inverter. Herein, the lower bridge arm switching transistors of the bridge arm a, the bridge arm b, and the bridge arm c may be damaged because the lower bridge arm switching transistors cannot bear the current Ic, thereby affecting normal functioning of the inverter.

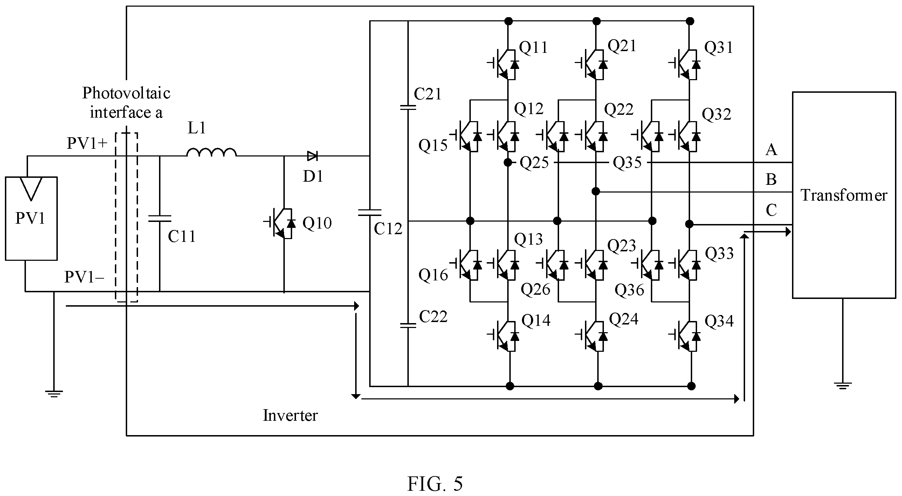

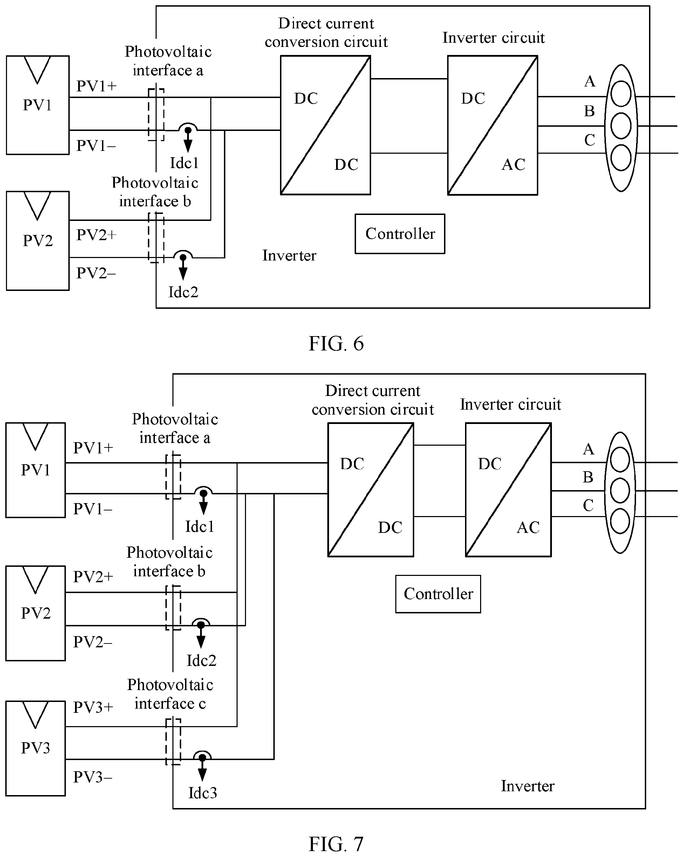

FIG. 5 is a diagram of another structure of a power generation system according to this application. As shown in FIG. 5, an inverter in FIG. 5 includes a direct current conversion circuit and an inverter circuit. The direct current conversion circuit may include a capacitor C11 and a capacitor C12. The capacitor C11 is connected in parallel to two ends of an inductor L1 and a switching transistor Q10 that are connected in series, one end of the capacitor C12 is connected to one end of the switching transistor Q10 through a diode D1, and the other end of the capacitor C12 is connected to the other end of the switching transistor Q10. The inverter circuit may include a capacitor C21, a capacitor C22, and three bridge arms (a bridge arm a, a bridge arm b, and a bridge arm c). The capacitor C21 and the capacitor C22 are connected in series and then connected in parallel to the two ends of the capacitor C12, bridge arm middle points of the bridge arm a, the bridge arm b, and the bridge arm c are respectively connected to a phase-A port, a phase-B port, and a phase-C port of the inverter, and the phase-A port, the phase-B port, and the phase-C port of the inverter may be connected to a primary-side winding of a transformer, and is grounded through the transformer. The bridge arm a may include four bridge arm switching transistors (which, for ease of description, may be represented as a switching transistor Q11, a switching transistor Q12, a switching transistor Q13, and a switching transistor Q14) connected in series, the switching transistor Q11, the switching transistor Q12, the switching transistor Q13, and the switching transistor Q14 are sequentially connected in series and connected in parallel to two ends of the capacitor C21 and the capacitor C22. The switching transistor Q13 and the switching transistor Q14 are lower bridge arm switching transistors of the bridge arm a, two ends of the switching transistor Q14 are connected in parallel to one diode, a positive electrode of the diode is connected to the capacitor C22, two ends of the switching transistor Q13 are connected in parallel to another diode, and a negative electrode of the diode is connected to a bridge arm middle point (a connection end between the switching transistor Q12 and the switching transistor Q13) of the bridge arm a. A connection end between the switching transistor Q11 and the switching transistor Q12 is connected to a connection end between the switching transistor Q13 and the switching transistor Q14 through two switching transistors (a switching transistor Q15 and a switching transistor Q16) connected in series, and a connection end between the switching transistor Q15 and the switching transistor Q16 is connected to a connection end between the capacitor C21 and the capacitor C22. The bridge arm middle point of the bridge arm a, namely, the connection end between the switching transistor Q12 and the switching transistor Q13, may be connected to the phase-A port. The bridge arm b may include a switching transistor Q21, a switching transistor Q22, a switching transistor Q23, a switching transistor Q24, a switching transistor Q25, and a switching transistor Q26, and the bridge arm c may include a switching transistor Q31, a switching transistor Q32, a switching transistor Q33, a switching transistor Q34, a switching transistor Q35, and a switching transistor Q36. It may be understood that, in the power converter shown in FIG. 7, circuit structures of the bridge arm b and the bridge arm c are the same as the circuit structure of the bridge arm a. Details are not described herein again. When a short-circuit to ground fault occurs on a negative branch PV1-corresponding to a photovoltaic string PV1, and a current Ic higher than a preset current threshold occurs on a current loop formed by the negative branch PV1- and the direct current conversion circuit, a lower bridge arm switching transistor in each bridge arm, and the transformer. The current Ic may flow to the bridge arm in the inverter circuit through the direct current conversion circuit, and damage the switching transistor included in the bridge arm. For example, the current Ic may flow to a lower bridge arm switching transistor (namely, the switching transistor Q32) in the bridge arm c through the direct current conversion circuit, and flow to the transformer through the phase-C port of the inverter. Herein, the lower bridge arm switching transistors of the bridge arm a, the bridge arm b, and the bridge arm c may be damaged because the lower bridge arm switching transistors cannot bear the current Ic, thereby affecting normal functioning of the inverter.

The following describes the inverter provided in embodiments of this application by using examples with reference to FIG. 6 to FIG. 17. In some feasible implementations, the inverter may include a plurality of photovoltaic interfaces, and one branch current sensor may be disposed on a negative branch corresponding to a negative interface of any photovoltaic interface. FIG. 6 is a diagram of another structure of an inverter according to this application. As shown in FIG. 6, for example, the inverter in FIG. 6 includes two photovoltaic interfaces, to be specific, the inverter may include a photovoltaic interface a and a photovoltaic interface b. A positive branch PV1+ and a negative branch PV1-that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. After being connected to each other, the positive branches corresponding to the photovoltaic interface a and the photovoltaic interface b may be connected to a positive input end of a direct current conversion circuit in the inverter. After being connected to each other, the negative branches corresponding to the photovoltaic interface a and the photovoltaic interface b may be connected to a negative input end of the direct current conversion circuit. An output end of the direct current conversion circuit is connected to an inverter circuit. One branch current sensor ldc1 may be disposed on the negative branch corresponding to the photovoltaic interface a, and may be specifically disposed between a connection end between the negative branch PV1- and the negative branch PV2- and the negative interface of the photovoltaic interface a. One branch current sensor ldc2 may be disposed on the negative branch corresponding to the photovoltaic interface b, and may be specifically disposed between a connection end between the negative branch PV1- and the negative branch PV2- and the negative interface of the photovoltaic interface b. The branch current sensor ldc1 and the branch current sensor ldc2 are respectively configured to measure current information of the negative branch PV1- and the negative branch PV2-, and upload the current information of the negative branches to a controller. The controller may obtain a current value A1 of the negative branch PV1- and a current value A2 of the negative branch PV2- based on the current information uploaded by the branch current sensor ldc1 and the branch current sensor ldc2. FIG. 7 is a diagram of another structure of an inverter according to this application. The inverter in FIG. 7 includes three photovoltaic interfaces, to be specific, the inverter may include a photovoltaic interface a, a photovoltaic interface b, and a photovoltaic interface c. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. A positive branch PV3+ and a negative branch PV3- that correspond to a positive interface and a negative interface of the photovoltaic interface c are each connected to a photovoltaic string PV3. After being connected to each other, the positive branches corresponding to the photovoltaic interface a, the photovoltaic interface b, and the photovoltaic interface c may be connected to a positive input end of a direct current conversion circuit in the inverter. After being connected to each other, the negative branches corresponding to the photovoltaic interface a, the photovoltaic interface b, and the photovoltaic interface c may be connected to a negative input end of the direct current conversion circuit. An output end of the direct current conversion circuit is connected to an inverter circuit. One branch current sensor ldc1 may be disposed on the negative branch corresponding to the photovoltaic interface a, and may be specifically disposed between a connection end between the negative branch PV1- and the negative branch PV2- and the negative interface of the photovoltaic interface a. One branch current sensor ldc2 may be disposed on the negative branch corresponding to the photovoltaic interface b, and may be specifically disposed between a connection end between the negative branch PV1- and the negative branch PV2- and the negative interface of the photovoltaic interface b. One branch current sensor ldc3 may be disposed on the negative branch corresponding to the photovoltaic interface c, and may be specifically disposed between a connection end between the negative branch PV1- and the negative branch PV3- and the negative interface of the photovoltaic interface c. The branch current sensor ldc1, the branch current sensor ldc2, and the branch current sensor ldc3 are respectively configured to measure current information of the negative branch PV1-, the negative branch PV2-, and the negative branch PV3-, and upload the current information of the negative branches to a controller. The controller may obtain a current value A1 of the negative branch PV1-, a current value A2 of the negative branch PV2-, and a current value A3 of the negative branch PV3-based on the current information uploaded by the branch current sensor ldc1, the branch current sensor ldc2, and the branch current sensor ldc3. The controller in FIG. 6 or FIG. 7 may determine, based on a current value of any negative branch and a preset current threshold, that the any negative branch is short-circuited, for example, detect that the current value A1 of the negative branch PV1- is greater than the preset current threshold.

To be specific, if a current value on a current loop formed by the negative branch PV1- and the direct current conversion circuit, a lower bridge arm switching transistor in the inverter circuit, and a transformer is greater than the preset current threshold, the controller determines that the negative branch PV1- is short-circuited to the ground. The controller generates an alarm prompt for one or more photovoltaic string cables that are short-circuited, facilitating repair or replacement of the photovoltaic string cable, so that the faulty cable is located quickly and accurately, to avoid a switching transistor in the inverter being damaged by overcurrent caused because the faulty photovoltaic string cable is short-circuited to the ground inside the inverter. This ensures reliable functioning of the inverter and improves power supply efficiency to the load.

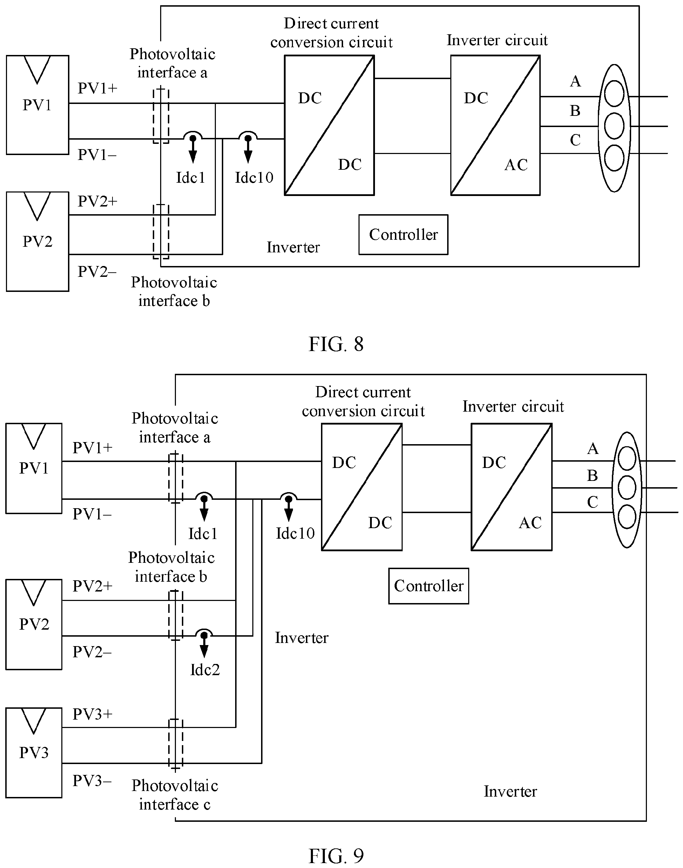

In some feasible implementations, the plurality of negative branches may be sequentially connected to a negative bus, and connected to the negative input end of the direct current conversion circuit through the negative bus. The plurality of negative branches may include a first negative branch, one branch current sensor may be disposed on the first negative branch, and the branch current sensor is located between a negative interface corresponding to the first negative branch and the negative bus. The plurality of negative branches may include a second negative branch, a combination current sensor is disposed at a connection end between the second negative branch and the negative bus, the second negative branch is located on the negative bus, and the combination current sensor is configured to measure current information of the connection end between the second negative branch and the negative bus, and upload the current information of the connection end between the second negative branch and the negative bus to the controller. FIG. 8 is a diagram of another structure of an inverter according to this application. As shown in FIG. 8, for example, the inverter in FIG. 8 includes two photovoltaic interfaces, to be specific, the inverter may include a photovoltaic interface a and a photovoltaic interface b. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. The positive branches may be sequentially connected to a positive bus, and connected to a positive input end of a direct current conversion circuit in the inverter through the positive bus. The negative branches may be sequentially connected to a negative bus, and connected to a negative input end of the direct current conversion circuit through the negative bus. An output end of the direct current conversion circuit is connected to an inverter circuit. One branch current sensor may be disposed on the negative branch PV1- or the negative branch PV2-. In FIG. 8, an example in which one branch current sensor ldc1 is disposed on the negative branch PV1- is used. That is, the negative branch PV1- is a first negative branch, and the negative branch PV2- is a second negative branch. The branch current sensor ldc1 may be disposed on the negative branch PV1-, and may be specifically disposed between the negative interface of the photovoltaic interface a and the negative bus. A combination current sensor ldc10 may be disposed on the negative bus, and may be specifically disposed between a connection end between the negative branch PV2- and the negative bus and the negative input end of the direct current conversion circuit. The branch current sensor ldc1 is configured to measure current information of the negative branch PV1-, and upload the current information to a controller. The controller may obtain a current value A1 of the negative branch PV1- based on the current information uploaded by the branch current sensor ldc1. The combination current sensor ldc10 is configured to measure current information of the connection end between the negative branch PV2- and the negative bus, and upload the current information to the controller. The controller may obtain a sum A0 of current values of the negative branch PV1- and the negative branch PV2- based on the current information, to obtain a current value A2 (A2=A0-A1) of the negative branch PV2-. The controller may determine, based on a current value of any negative branch and a preset current threshold, that the any negative branch is short-circuited, for example, detect that the current value A1 of the negative branch PV1- is greater than the preset current threshold. To be specific, if a current value on a current loop formed by the negative branch PV1- and the direct current conversion circuit, a lower bridge arm switching transistor in the inverter circuit, and a transformer is greater than the preset current threshold, the controller determines that the negative branch PV1- is short-circuited to the ground. The controller generates an alarm prompt for one or more photovoltaic string cables that are short-circuited, facilitating repair or replacement of the photovoltaic string cable, so that the faulty cable is located quickly and accurately, to avoid a switching transistor in the inverter being damaged by overcurrent caused because the faulty photovoltaic string cable is short-circuited to the ground inside the inverter. This ensures reliable functioning of the inverter and improves power supply efficiency to the load. Herein, the current sensor ldc10 may further perform maximum power point tracking on the photovoltaic string PV1 and the photovoltaic string PV2.

FIG. 9 is a diagram of another structure of an inverter according to this application. As shown in FIG. 9, the inverter in FIG. 9 includes three photovoltaic interfaces, to be specific, the inverter may include a photovoltaic interface a, a photovoltaic interface b, and a photovoltaic interface c. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. A positive branch PV3+ and a negative branch PV3- that correspond to a positive interface and a negative interface of the photovoltaic interface c are each connected to a photovoltaic string PV3. The positive branches may be sequentially connected to a positive bus, and connected to a positive input end of a direct current conversion circuit in the inverter through the positive bus. The negative branches may be sequentially connected to a negative bus, and connected to a negative input end of the direct current conversion circuit through the negative bus. An output end of the direct current conversion circuit is connected to an inverter circuit. A branch current sensor ldc1 may be disposed on the negative branch PV1-, and may be specifically disposed between the negative interface of the photovoltaic interface a and the negative bus. A branch current sensor ldc2 may be disposed on the negative branch PV2-, and may be specifically disposed between the negative interface of the photovoltaic interface b and the negative bus. A combination current sensor ldc10 may be disposed on the negative bus, and may be specifically disposed between a connection end between the negative branch PV3- and the negative bus and the negative input end of the direct current conversion circuit. A controller may obtain a current value A1 of the negative branch PV1- based on current information uploaded by the branch current sensor ldc1, may obtain a current value A2 of the negative branch PV2- based on current information uploaded by the branch current sensor ldc2, and obtain a sum A0 of current values of the negative branch PV1-, the negative branch PV2-, and the negative branch PV3- based on current information uploaded by the combination current sensor ldc10, to obtain a current value A3 (A3=A0-A1-A2) of the negative branch PV3-. The controller may determine, based on a current value of any negative branch and a preset current threshold, that the any negative branch is short-circuited, for example, detect that the current value A1 of the negative branch PV1- is greater than the preset current threshold. To be specific, if a current value on a current loop formed by the negative branch PV1- and the direct current conversion circuit, a lower bridge arm switching transistor in the inverter circuit, and a transformer is greater than the preset current threshold, the controller determines that the negative branch PV1- is short-circuited to the ground. The controller generates an alarm prompt for one or more photovoltaic string cables that are short-circuited, facilitating repair or replacement of the photovoltaic string cable, so that the faulty cable is located quickly and accurately, to avoid a switching transistor in the inverter being damaged by overcurrent caused because the faulty photovoltaic string cable is short-circuited to the ground inside the inverter. This ensures reliable functioning of the inverter and improves power supply efficiency to the load. Herein, the current sensor ldc10 may further perform maximum power point tracking on the photovoltaic string PV1, the photovoltaic string PV2, and the photovoltaic string PV3.

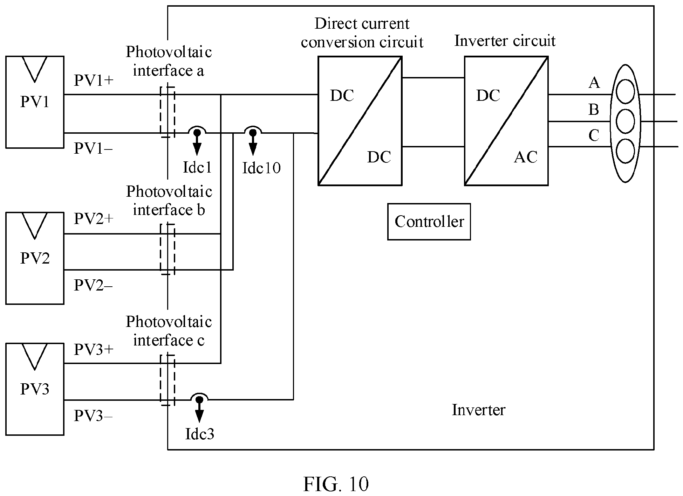

FIG. 10 is a diagram of another structure of an inverter according to this application. As shown in FIG. 10, the inverter in FIG. 10 includes three photovoltaic interfaces, to be specific, the inverter may include a photovoltaic interface a, a photovoltaic interface b, and a photovoltaic interface c. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. A positive branch PV3+ and a negative branch PV3- that correspond to a positive interface and a negative interface of the photovoltaic interface c are each connected to a photovoltaic string PV3. The positive branches may be sequentially connected to a positive bus, and connected to a positive input end of a direct current conversion circuit in the inverter through the positive bus. The negative branches may be sequentially connected to a negative bus, and connected to a negative input end of the direct current conversion circuit through the negative bus. An output end of the direct current conversion circuit is connected to an inverter circuit. A branch current sensor ldc1 may be disposed on the negative branch PV1-, and may be specifically disposed between the negative interface of the photovoltaic interface a and the negative bus. A branch current sensor ldc3 may be disposed on the negative branch PV3-, and may be specifically disposed between the negative interface of the photovoltaic interface c and the negative bus. A combination current sensor ldc10 may be disposed on the negative bus, and may be specifically disposed between a connection end between the negative branch PV2- and the negative bus and the negative input end of the direct current conversion circuit. A controller may obtain a current value A1 of the negative branch PV1- based on current information uploaded by the branch current sensor ldc1, may obtain a current value A3 of the negative branch PV3- based on current information uploaded by the branch current sensor ldc3, and obtain a sum A0 of current values of the negative branch PV1- and the negative branch PV2- based on current information uploaded by the combination current sensor ldc10, to obtain a current value A2 (A2=A0-A1) of the negative branch PV2-. The controller may determine, based on a current value of any negative branch and a preset current threshold, that the any negative branch is short-circuited. The controller generates an alarm prompt for one or more photovoltaic string cables that are short-circuited, facilitating repair or replacement of the photovoltaic string cable, so that the faulty cable is located quickly and accurately, to avoid a switching transistor in the inverter being damaged by overcurrent caused because the faulty photovoltaic string cable is short-circuited to the ground inside the inverter. This ensures reliable functioning of the inverter, and improves power supply efficiency to the load. Herein, the current sensor ldc10 may further perform maximum power point tracking on the photovoltaic string PV1, the photovoltaic string PV2, and the photovoltaic string PV3.

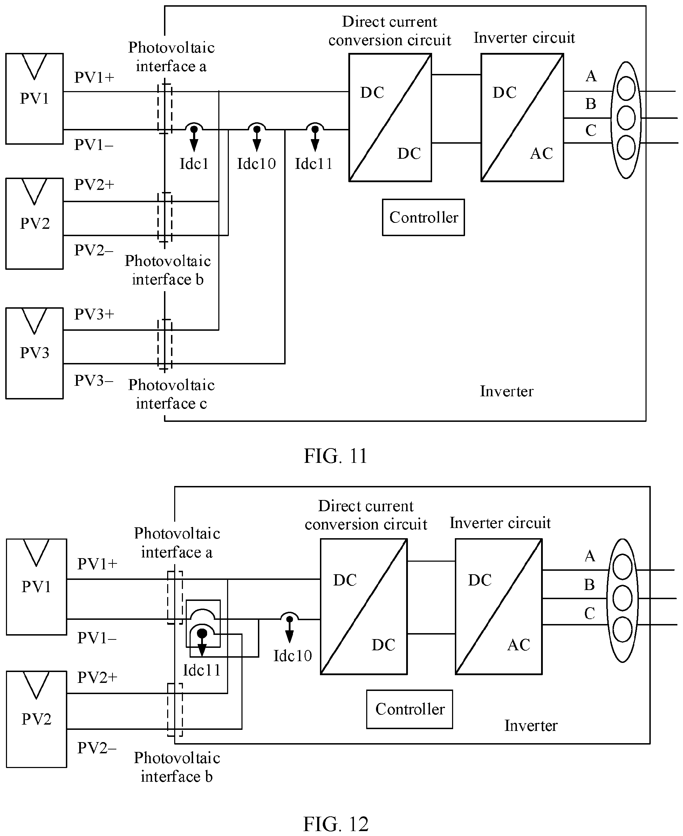

FIG. 11 is a diagram of another structure of an inverter according to this application. As shown in FIG. 11, the inverter in FIG. 11 includes three photovoltaic interfaces, to be specific, the inverter may include a photovoltaic interface a, a photovoltaic interface b, and a photovoltaic interface c. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. A positive branch PV3+ and a negative branch PV3- that correspond to a positive interface and a negative interface of the photovoltaic interface c are each connected to a photovoltaic string PV3. The positive branches may be sequentially connected to a positive bus, and connected to a positive input end of a direct current conversion circuit in the inverter through the positive bus. The negative branches may be sequentially connected to a negative bus, and connected to a negative input end of the direct current conversion circuit through the negative bus. An output end of the direct current conversion circuit is connected to an inverter circuit. A branch current sensor ldc1 may be disposed on the negative branch PV1-, and may be specifically disposed between the negative interface of the photovoltaic interface a and the negative bus. A combination current sensor ldc10 may be disposed on the negative bus, and may be specifically disposed between a connection end between the negative branch PV2- and the negative bus and the negative input end of the direct current conversion circuit. A combination current sensor ldc1 1 may be disposed on the negative bus, and may be specifically disposed between a connection end between the negative branch PV3- and the negative bus and the negative input end of the direct current conversion circuit. A controller may obtain a current value A1 of the negative branch PV1- based on current information uploaded by the branch current sensor ldc1, obtain a sum A0 of current values of the negative branch PV1- and the negative branch PV2- based on current information uploaded by the combination current sensor ldc 10, and obtain a sum B0 of current values of the negative branch PV1-, the negative branch PV2-, and the negative branch PV3- based on the current information uploaded by the combination current sensor ldc10, to obtain a current value A2 (A2=A0-A1) of the negative branch PV2-, and obtain a current value A3 (A3=B0-A0) of the negative branch PV3-. The controller may determine, based on a current value of any negative branch and a preset current threshold, that the any negative branch is short-circuited. The controller generates an alarm prompt for one or more photovoltaic string cables that are short-circuited, facilitating repair or replacement of the photovoltaic string cable, so that the faulty cable is located quickly and accurately, to avoid a switching transistor in the inverter being damaged by overcurrent caused because the faulty photovoltaic string cable is short-circuited to the ground inside the inverter. This ensures reliable functioning of the inverter and improves power supply efficiency to the load. Herein, the current sensor ldc10 may further perform maximum power point tracking on the photovoltaic string PV1, the photovoltaic string PV2, and the photovoltaic string PV3.

In some feasible implementations, the inverter may include N photovoltaic interfaces, N negative branches corresponding to the N photovoltaic interfaces may include N-1 first negative branches and one second negative branch, one branch current sensor may be disposed on each first negative branch, the branch current sensor is located between a negative interface corresponding to each first negative branch and the negative bus, one combination current sensor is disposed between the negative input end of the direct current conversion circuit and a connection end between the second negative branch and the negative bus, and N is a positive integer greater than 1. The controller may obtain current values of the N-1 first negative branches based on current information obtained by branch current sensors disposed on the N-1 first negative branches, obtain a sum of current values of the N negative branches based on current information obtained by the combination current sensor, and subtract a sum of the current values of the N-1 first negative branches from the sum of the current values of the N negative branches, to obtain a current value of the second negative branch, to obtain a current value of any negative branch. The controller generates an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load.

In some feasible implementations, the inverter may include a first photovoltaic interface and a second photovoltaic interface, positive branches corresponding to the first photovoltaic interface and the second photovoltaic interface are connected to the positive input end of the direct current conversion circuit after being connected to each other, one branch current difference sensor may be disposed on a negative branch corresponding to a negative interface of the first photovoltaic interface, a negative branch corresponding to a negative interface of the second photovoltaic interface may be connected, through the branch current difference sensor, to the negative branch corresponding to the negative interface of the first photovoltaic interface, and a connection end between the negative branches corresponding to the negative interfaces of the first photovoltaic interface and the second photovoltaic interface may be connected to the negative input end of the direct current conversion circuit through one combination current sensor. FIG. 12 is a diagram of another structure of an inverter according to this application. As shown in FIG. 12, the inverter in FIG. 12 may include a photovoltaic interface a and a photovoltaic interface b. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. After being connected to each other, the positive branches corresponding to the photovoltaic interface a and the photovoltaic interface b may be connected to a positive input end of a direct current conversion circuit in the inverter. One branch current difference sensor ldcll may be disposed on the negative branch PV1- corresponding to the photovoltaic interface a, and may be specifically disposed between a connection end between the negative branch PV1- and the negative branch PV2- and the photovoltaic interface a. The negative branch PV2- corresponding to the photovoltaic interface b may be connected, through the branch current difference sensor ldc11, to the negative branch PV1- corresponding to a negative interface of a first photovoltaic interface, and a connection end between the negative branch PV1- and the negative branch PV2- may be connected to a negative input end of the direct current conversion circuit through one combination current sensor ldc10. A controller in the inverter may obtain a difference S2 (S2=A 1-A2) between currents of the negative branch PV1- and the negative branch PV2- based on the branch current difference sensor ldc11, and obtain a sum S1 (S1=A1+A2) of current values of the negative branch PV1- and the negative branch PV2- based on the combination current sensor ldc10, to separately obtain the current value A1 of the negative branch PV1- and the current value A2 of the negative branch PV2-. The controller may determine, based on a current value of any negative branch and a preset current threshold, that the any negative branch is short-circuited, for example, if detecting that the current value A1 of the negative branch PV1- is greater than the preset current threshold, determine that the negative branch PV1- is short-circuited to the ground. The controller generates an alarm prompt for one or more photovoltaic string cables that are short-circuited, facilitating repair or replacement of the photovoltaic string cable, so that the faulty cable is located quickly and accurately, to avoid a switching transistor in the inverter being damaged by overcurrent caused because the faulty photovoltaic string cable is short-circuited to the ground inside the inverter. This ensures reliable functioning of the inverter and improves power supply efficiency to the load. Herein, the current sensor ldc10 may further perform maximum power point tracking on the photovoltaic string PV1 and the photovoltaic string PV2.

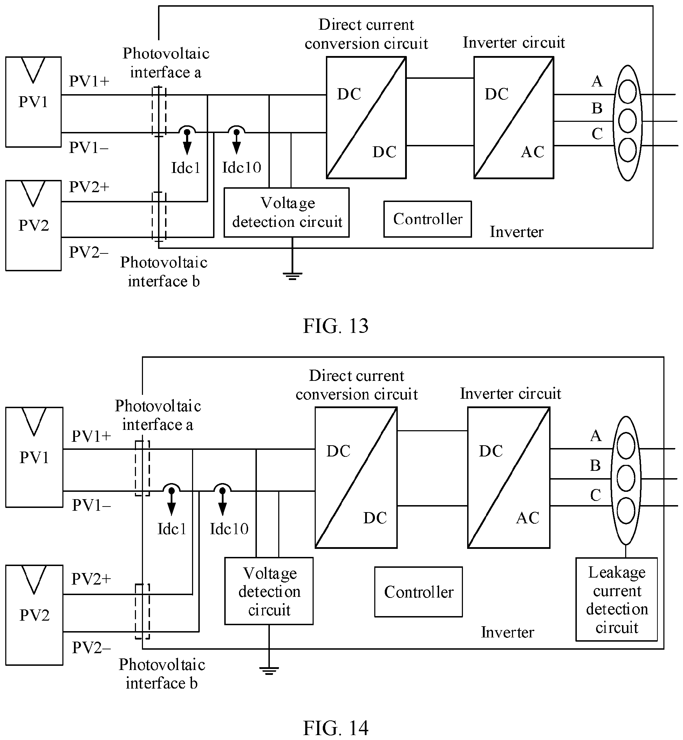

In some feasible implementations, the inverter may include a voltage detection circuit, and the voltage detection circuit may obtain a negative photovoltaic voltage value at the negative input end of the direct current conversion circuit in the inverter. For example, the inverter shown in FIG. 8 includes the voltage detection circuit. FIG. 13 is a diagram of another structure of an inverter according to this application. The inverter in FIG. 13 may include a photovoltaic interface a and a photovoltaic interface b. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. After being connected to each other, the positive branches corresponding to the photovoltaic interface a and the photovoltaic interface b may be connected to a positive input end of a direct current conversion circuit in the inverter. After being connected to each other, the negative branches corresponding to the photovoltaic interface a and the photovoltaic interface b may be connected to a negative input end of the direct current conversion circuit. An output end of the direct current conversion circuit is connected to an inverter circuit. A branch current sensor ldc1 may be disposed between a connection end between the negative branch PV1- and the negative branch PV2- and the photovoltaic interface a. One combination current sensor ldc10 may be disposed between the connection end between the negative branch PV1- and the negative branch PV2- and the negative input end of the direct current conversion circuit. The inverter may further include a voltage detection circuit. Two input ends of the voltage detection circuit are respectively connected to the positive input end and a second input end of the direct current conversion circuit. A controller may obtain a negative photovoltaic voltage value at the negative input end of the direct current conversion circuit through the voltage detection circuit, and determine that negative branches corresponding to some of a plurality of photovoltaic ports are short-circuited to the ground, for example, if detecting that the negative photovoltaic voltage value is greater than a voltage threshold and a current value A1 of the negative branch PV1- is greater than a preset current threshold, determine that the negative branch PV1- is short-circuited to the ground, and send short-circuit fault information that includes a location of the negative branch PV1-. Herein, when detecting that negative photovoltaic voltage value is greater than the voltage threshold, the controller determines that the negative branches corresponding to some of the plurality of photovoltaic ports are short-circuited to the ground, and then locates, based on a current value of each negative branch, a negative branch that is short-circuited. In this way, misjudgment of the faulty negative branch can be reduced, and accuracy of locating the faulty cable is further improved.

In some feasible implementations, the inverter may include a leakage current detection circuit, and the leakage current detection circuit may obtain an output leakage current of the inverter circuit in the inverter. For example, the inverter shown in FIG. 13 includes the voltage detection circuit. FIG. 14 is a diagram of another structure of an inverter according to this application. The inverter in FIG. 14 may include a photovoltaic interface a and a photovoltaic interface b. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. After being connected to each other, the positive branches corresponding to the photovoltaic interface a and the photovoltaic interface b may be connected to a positive input end of a direct current conversion circuit in the inverter. After being connected to each other, the negative branches corresponding to the photovoltaic interface a and the photovoltaic interface b may be connected to a negative input end of the direct current conversion circuit. An output end of the direct current conversion circuit is connected to an inverter circuit. A branch current sensor ldc1 may be disposed between a connection end between the negative branch PV1- and the negative branch PV2- and the photovoltaic interface a. One combination current sensor ldc10 may be disposed between the connection end between the negative branch PV1- and the negative branch PV2- and the negative input end of the direct current conversion circuit. The inverter may further include a leakage current detection circuit, and the leakage current detection circuit may be connected to three phases of output ends (which may include a phase-A port, a phase-B port, and a phase-C port) of the inverter circuit. A controller may obtain a difference between currents of any two phases of output ends of the three phases of output ends of the inverter circuit through the leakage current detection circuit, and determine, in response to that a negative photovoltaic voltage value is greater than a voltage threshold, and a difference between the currents of the any two phases of output ends of the three phases of output ends is greater than a specified threshold, that negative branches corresponding to some of a plurality of photovoltaic ports are short-circuited to the ground, for example, if detecting that the negative photovoltaic voltage value is greater than the voltage threshold, a difference between a current of the phase-A port and a current of the phase-B port is greater than the specified threshold, and a current value A1 of the negative branch PV1- is greater than a preset current threshold, determine that the negative branch PV1- is short-circuited to the ground, and send short-circuit fault information that includes a location of the negative branch PV1-. Herein, when detecting that the negative photovoltaic voltage value is greater than the voltage threshold and the difference between the currents of the any two phases of output ends of the three phases of output ends is greater than the specified threshold, the controller determines that the negative branches corresponding to some of the plurality of photovoltaic ports are short-circuited to the ground, and then locates, based on a current value of each negative branch, a negative branch that is short-circuited. In this way, misjudgment of the faulty negative branch can be reduced, and accuracy of locating the faulty cable is further improved.

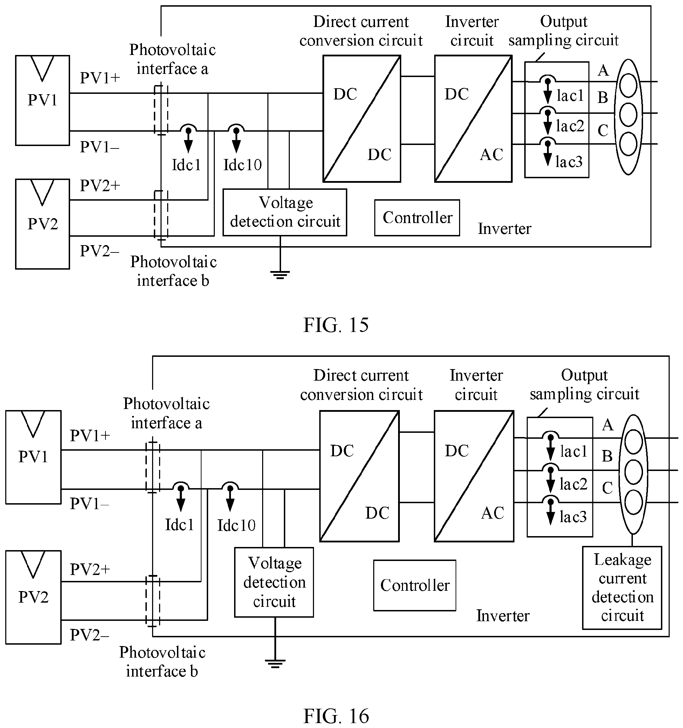

In some feasible implementations, the inverter may include an output sampling circuit, and the output sampling circuit may obtain three phases of output currents of the inverter circuit in the inverter. For example, the inverter shown in FIG. 13 includes the voltage detection circuit. FIG. 15 is a diagram of another structure of an inverter according to this application. The inverter in FIG. 15 may include a photovoltaic interface a and a photovoltaic interface b. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. After being connected to each other, the positive branches corresponding to the photovoltaic interface a and the photovoltaic interface b may be connected to a positive input end of a direct current conversion circuit in the inverter. After being connected to each other, the negative branches corresponding to the photovoltaic interface a and the photovoltaic interface b may be connected to a negative input end of the direct current conversion circuit. An output end of the direct current conversion circuit is connected to an inverter circuit. A branch current sensor ldc1 may be disposed between a connection end between the negative branch PV1- and the negative branch PV2- and the photovoltaic interface a. One combination current sensor ldc10 may be disposed between the connection end between the negative branch PV1- and the negative branch PV2- and the negative input end of the direct current conversion circuit. The inverter may further include an output sampling circuit, the output sampling circuit may include a current sensor lac1, a current sensor lac2, and a current sensor lac3, and the current sensor lac1, the current sensor lac2, and the current sensor lac3 are respectively connected to a phase-A port, a phase-B port, and a phase-C port. A controller may obtain three phases of output currents of the inverter circuit through the output sampling circuit, and determine, in response to that a negative photovoltaic voltage value is greater than a voltage threshold, and a difference between currents of any two phases of output ends of the three phases of output ends is greater than a specified threshold, that negative branches corresponding to some of a plurality of photovoltaic ports are short-circuited to the ground, for example, if detecting that the negative photovoltaic voltage value is greater than the voltage threshold, a difference between a current of the phase-A port and a current of the phase-B port is greater than the specified threshold, and a current value A1 of the negative branch PV1- is greater than a preset current threshold, determine that the negative branch PV1- is short-circuited to the ground, and send short-circuit fault information that includes a location of the negative branch PV1-. Herein, when detecting that the negative photovoltaic voltage value is greater than the voltage threshold and the difference between the currents of the any two phases of output ends of the three phases of output ends is greater than the specified threshold, the controller determines that the negative branches corresponding to some of the plurality of photovoltaic ports are short-circuited to the ground, and then locates, based on a current value of each negative branch, a negative branch that is short-circuited. In this way, misjudgment of the faulty negative branch can be reduced, and accuracy of locating the faulty cable is further improved.

In some feasible implementations, the inverter may include an output voltage detection circuit, a leakage current detection circuit, and an output sampling circuit. FIG. 16 is a diagram of another structure of an inverter according to this application. The inverter in FIG. 16 may include a voltage detection circuit. Two input ends of the voltage detection circuit are respectively connected to a positive input end and a second input end of a direct current conversion circuit. A controller may obtain a negative photovoltaic voltage value at a negative input end of the direct current conversion circuit through the voltage detection circuit. The inverter may include a leakage current detection circuit, and the leakage current detection circuit may be connected to three phases of output ends (which may include a phase-A port, a phase-B port, and a phase-C port) of an inverter circuit. The controller may obtain a difference between currents of any two phases of output ends of the three phases of output ends of the inverter circuit through the leakage current detection circuit. The inverter may include an output sampling circuit, the output sampling circuit may include a current sensor lac1, a current sensor lac2, and a current sensor lac3, and the current sensor lac1, the current sensor lac2, and the current sensor lac3 are respectively connected to the phase-A port, the phase-B port, and the phase-C port. The controller may obtain the three phases of output currents of the inverter circuit through the output sampling circuit. The inverter may determine, in response to that the negative photovoltaic voltage value is greater than a voltage threshold, and a difference between currents of any two phases of output ends of the three phases of output ends is greater than a specified threshold (which may be that both the difference obtained by the leakage current detection circuit and the difference obtained by the output sampling circuit are greater than the specified threshold), that negative branches corresponding to some of a plurality of photovoltaic ports are short-circuited to the ground.

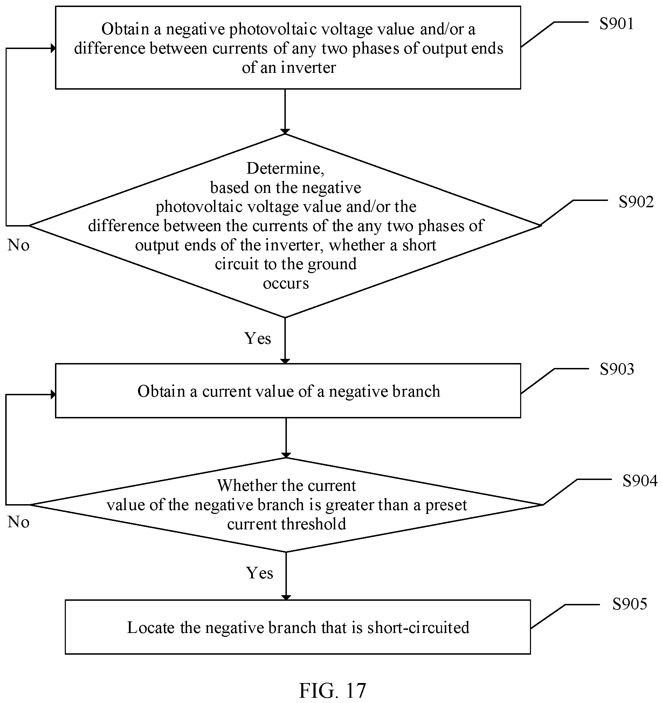

FIG. 17 is a schematic flowchart of a short-circuit detection method for a negative branch of an inverter according to this application. The short-circuit detection method for the negative branch of the inverter according to this application is applicable to the inverter shown in FIG. 1 to FIG. 16. The inverter includes a plurality of photovoltaic interfaces, a direct current conversion circuit, an inverter circuit, and a controller. Positive interfaces of the plurality of photovoltaic interfaces are connected to a positive input end of the direct current conversion circuit after being converged through a plurality of positive branches, negative interfaces of the plurality of photovoltaic interfaces are connected to a negative input end of the direct current conversion circuit after being converged through a plurality of negative branches, and an output end of the direct current conversion circuit is connected to the inverter circuit. Current sensors are disposed on some or all of negative branches corresponding to the negative interfaces of the plurality of photovoltaic interfaces. As shown in FIG. 17, the short-circuit detection method for the negative branch of the inverter according to this application includes the following steps.

S901: Obtain a negative photovoltaic voltage value and/or a difference between currents of any two phases of output ends of the inverter.

S902: Determine, based on the negative photovoltaic voltage value and/or the difference between the currents of the any two phases of output ends of the inverter, whether a short circuit to the ground occurs; and if a determining result is yes, perform step S903; or if a determining result is no, perform step S901.

In some feasible implementations, the inverter may include a voltage detection circuit, and the voltage detection circuit may obtain a negative photovoltaic voltage value at the negative input end of the direct current conversion circuit in the inverter. Refer to the inverter shown in FIG. 13. The inverter in FIG. 13 may further include a voltage detection circuit. Two input ends of the voltage detection circuit are respectively connected to the positive input end and a second input end of the direct current conversion circuit. A controller may obtain the negative photovoltaic voltage value at the negative input end of the direct current conversion circuit through the voltage detection circuit, and determine that negative branches corresponding to some of a plurality of photovoltaic ports are short-circuited to the ground, for example, if detecting that the negative photovoltaic voltage value is greater than a voltage threshold and a current value A1 of a negative branch PV1- is greater than a preset current threshold, determine that the negative branch PV1- is short-circuited to the ground, and send short-circuit fault information that includes a location of the negative branch PV1-.

In some feasible implementations, the inverter may include a leakage current detection circuit, and the leakage current detection circuit may obtain an output leakage current of the inverter circuit in the inverter. Refer to the inverter shown in FIG. 14. The inverter in FIG. 14 may include a voltage detection circuit and a leakage current detection circuit, and the leakage current detection circuit may be connected to three phases of output ends (which may include a phase-A port, a phase-B port, and a phase-C port) of the inverter circuit. A controller may obtain a difference between currents of any two phases of output ends of the three phases of output ends of the inverter circuit through the leakage current detection circuit, and determine, in response to that a negative photovoltaic voltage value is greater than a voltage threshold, and a difference between the currents of the any two phases of output ends of the three phases of output ends is greater than a specified threshold, that negative branches corresponding to some of a plurality of photovoltaic ports are short-circuited to the ground, for example, if detecting that the negative photovoltaic voltage value is greater than the voltage threshold, a difference between a current of the phase-A port and a current of the phase-B port is greater than the specified threshold, and a current value A1 of the negative branch PV1- is greater than a preset current threshold, determine that the negative branch PV1- is short-circuited to the ground, and send the short-circuit fault information that includes a location of the negative branch PV1-.

In some feasible implementations, the inverter may include an output sampling circuit, and the output sampling circuit may obtain three phases of output currents of the inverter circuit in the inverter. Refer to the inverter shown in FIG. 15. The inverter in FIG. 15 may include an output sampling circuit, the output sampling circuit may include a current sensor lac1, a current sensor lac2, and a current sensor lac3, and the current sensor lac1, the current sensor lac2, and the current sensor lac3 are respectively connected to a phase-A port, a phase-B port, and a phase-C port. A controller may obtain three phases of output currents of the inverter circuit through the output sampling circuit, and determine, in response to that a negative photovoltaic voltage value is greater than a voltage threshold, and a difference between currents of any two phases of output ends of the three phases of output ends is greater than a specified threshold, that negative branches corresponding to some of a plurality of photovoltaic ports are short-circuited to the ground, for example, if detecting that the negative photovoltaic voltage value is greater than the voltage threshold, a difference between a current of the phase-A port and a current of the phase-B port is greater than the specified threshold, and a current value A1 of the negative branch PV1- is greater than a preset current threshold, determine that the negative branch PV1- is short-circuited to the ground, and send the short-circuit fault information that includes a location of the negative branch PV1-.

In some feasible implementations, the inverter may include an output voltage detection circuit, a leakage current detection circuit, and an output sampling circuit. Refer to the inverter shown in FIG. 16. The inverter in FIG. 16 may include a voltage detection circuit. Two input ends of the voltage detection circuit are respectively connected to a positive input end and a second input end of a direct current conversion circuit. A controller may obtain a negative photovoltaic voltage value at a negative input end of the direct current conversion circuit through the voltage detection circuit. The inverter may include a leakage current detection circuit, and the leakage current detection circuit may be connected to three phases of output ends (which may include a phase-A port, a phase-B port, and a phase-C port) of an inverter circuit. The controller may obtain a difference between currents of any two phases of output ends of the three phases of output ends of the inverter circuit through the leakage current detection circuit. The inverter may include an output sampling circuit, the output sampling circuit may include a current sensor lac1, a current sensor lac2, and a current sensor lac3, and the current sensor lac1, the current sensor lac2, and the current sensor lac3 are respectively connected to the phase-A port, the phase-B port, and the phase-C port. The controller may obtain three phases of output currents of the inverter circuit through the output sampling circuit. The inverter may determine, in response to that the negative photovoltaic voltage value is greater than a voltage threshold, and a difference between currents of any two phases of output ends of the three phases of output ends is greater than a specified threshold (which may be that both the difference obtained by the leakage current detection circuit and the difference obtained by the output sampling circuit are greater than the specified threshold), that negative branches corresponding to some of a plurality of photovoltaic ports are short-circuited to the ground.

S903: Obtain a current value of the negative branch.

S904: Determine whether the current value of the negative branch is greater than the preset current threshold, and if a determining result is yes, perform step S905; or if a determining result is no, perform step S903.

S905: Locate the negative branch that is short-circuited.

In some feasible implementations, the inverter may include a plurality of photovoltaic interfaces, and one branch current sensor may be disposed on a negative branch corresponding to a negative interface of any photovoltaic interface. Refer to FIG. 6 together. The inverter in FIG. 6 includes two photovoltaic interfaces, to be specific, the inverter may include a photovoltaic interface a and a photovoltaic interface b. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. After being connected to each other, the positive branches corresponding to the photovoltaic interface a and the photovoltaic interface b may be connected to a positive input end of a direct current conversion circuit in the inverter. After being connected to each other, the negative branches corresponding to the photovoltaic interface a and the photovoltaic interface b may be connected to a negative input end of the direct current conversion circuit. An output end of the direct current conversion circuit is connected to an inverter circuit. One branch current sensor ldc1 may be disposed on the negative branch corresponding to the photovoltaic interface a, and may be specifically disposed between a connection end between the negative branch PV1- and the negative branch PV2- and the negative interface of the photovoltaic interface a. One branch current sensor ldc2 may be disposed on the negative branch corresponding to the photovoltaic interface b, and may be specifically disposed between a connection end between the negative branch PV1- and the negative branch PV2- and the negative interface of the photovoltaic interface b. The branch current sensor ldc1 and the branch current sensor ldc2 are respectively configured to measure current information of the negative branch PV1- and the negative branch PV2-, and upload the current information of the negative branches to a controller. The controller may obtain a current value A1 of the negative branch PV1- and a current value A2 of the negative branch PV2- based on the current information uploaded by the branch current sensor ldc1 and the branch current sensor ldc2.

In some feasible implementations, the plurality of negative branches may be sequentially connected to a negative bus, and connected to the negative input end of the direct current conversion circuit through the negative bus. The plurality of negative branches may include a first negative branch, one branch current sensor may be disposed on the first negative branch, and the branch current sensor is located between a negative interface corresponding to the first negative branch and the negative bus. The plurality of negative branches may include a second negative branch, a combination current sensor is disposed at a connection end between the second negative branch and the negative bus, the second negative branch is located on the negative bus, and the combination current sensor is configured to measure current information of the connection end between the second negative branch and the negative bus, and upload the current information of the connection end between the second negative branch and the negative bus to the controller. Refer to FIG. 8 together. The inverter in FIG. 8 includes two photovoltaic interfaces, to be specific, the inverter may include a photovoltaic interface a and a photovoltaic interface b. A positive branch PV1+ and a negative branch PV1-that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. The positive branches may be sequentially connected to a positive bus, and connected to a positive input end of a direct current conversion circuit in the inverter through the positive bus. The negative branches may be sequentially connected to a negative bus, and connected to a negative input end of the direct current conversion circuit through the negative bus. An output end of the direct current conversion circuit is connected to an inverter circuit. One branch current sensor may be disposed on the negative branch PV1- or the negative branch PV2-. In FIG. 8, an example in which one branch current sensor ldc1 is disposed on the negative branch PV1- is used. That is, the negative branch PV1- is a first negative branch, and the negative branch PV2- is a second negative branch. The branch current sensor ldc1 may be disposed on the negative branch PV1-, and may be specifically disposed between the negative interface of the photovoltaic interface a and the negative bus. A combination current sensor ldc10 may be disposed on the negative bus, and may be specifically disposed between a connection end between the negative branch PV2- and the negative bus and the negative input end of the direct current conversion circuit. The branch current sensor ldc1 is configured to measure current information of the negative branch PV1-, and upload the current information to a controller. The controller may obtain a current value A1 of the negative branch PV1- based on the current information uploaded by the branch current sensor ldc1. The combination current sensor ldc10 is configured to measure current information of the connection end between the negative branch PV2- and the negative bus, and upload the current information to the controller. The controller may obtain a sum A0 of current values of the negative branch PV1- and the negative branch PV2- based on the current information, to obtain a current value A2 (A2=A0-A1) of the negative branch PV2-.

In some feasible implementations, the inverter may include a first photovoltaic interface and a second photovoltaic interface, positive branches corresponding to the first photovoltaic interface and the second photovoltaic interface are connected to the positive input end of the direct current conversion circuit after being connected to each other, one branch current difference sensor may be disposed on a negative branch corresponding to a negative interface of the first photovoltaic interface, a negative branch corresponding to a negative interface of the second photovoltaic interface may be connected, through the branch current difference sensor, to the negative branch corresponding to the negative interface of the first photovoltaic interface, and a connection end between the negative branches corresponding to the negative interfaces of the first photovoltaic interface and the second photovoltaic interface may be connected to the negative input end of the direct current conversion circuit through one combination current sensor. Refer to FIG. 12 together. The inverter in FIG. 12 may include a photovoltaic interface a and a photovoltaic interface b. A positive branch PV1+ and a negative branch PV1- that correspond to a positive interface and a negative interface of the photovoltaic interface a are each connected to a photovoltaic string PV1. A positive branch PV2+ and a negative branch PV2- that correspond to a positive interface and a negative interface of the photovoltaic interface b are each connected to a photovoltaic string PV2. After being connected to each other, the positive branches corresponding to the photovoltaic interface a and the photovoltaic interface b may be connected to a positive input end of a direct current conversion circuit in the inverter. One branch current difference sensor ldc11 may be disposed on the negative branch PV1- corresponding to the photovoltaic interface a, and may be specifically disposed between a connection end between the negative branch PV1- and the negative branch PV2- and the photovoltaic interface a. The negative branch PV2- corresponding to the photovoltaic interface b may be connected, through the branch current difference sensor ldc11, to the negative branch PV1- corresponding to a negative interface of a first photovoltaic interface, and a connection end between the negative branch PV1- and the negative branch PV2- may be connected to a negative input end of the direct current conversion circuit through one combination current sensor ldc10. A controller in the inverter may obtain a difference S2 (S2=A1-A2) between currents of the negative branch PV1- and the negative branch PV2- based on the branch current difference sensor ldc11, and obtain a sum S1 (S1=A1+A2) of current values of the negative branch PV1- and the negative branch PV2- based on the combination current sensor ldc10, to separately obtain the current value A1 of the negative branch PV1- and the current value A2 of the negative branch PV2-. The controller may determine, based on a current value of any negative branch and a preset current threshold, that the any negative branch is short-circuited, for example, if detecting that the current value A1 of the negative branch PV1- is greater than the preset current threshold, determine that the negative branch PV1- is short-circuited to the ground. The controller generates an alarm prompt for one or more photovoltaic string cables that are short-circuited, facilitating repair or replacement of the photovoltaic string cable, so that the faulty cable is located quickly and accurately, to avoid overcurrent caused because the faulty photovoltaic string cable is short-circuited to the ground inside the inverter. This ensures reliable functioning of the inverter and improves power supply efficiency to the load. In this application, the inverter may include the plurality of photovoltaic interfaces. The photovoltaic interface of the inverter may be connected to a photovoltaic string through a negative branch and a positive branch. Specifically, after being connected to each other, positive branches corresponding to the plurality of photovoltaic interfaces may be connected to a positive input end of a direct current conversion circuit in the inverter. After being connected to each other, negative branches corresponding to negative interfaces of the plurality of photovoltaic interfaces may be connected to a negative input end of the direct current conversion circuit. An output end of the direct current conversion circuit is connected to an inverter circuit. On the negative branches corresponding to the negative interfaces of the plurality of photovoltaic interfaces, current sensors may be disposed on some or all of the negative branches. The current sensor may be disposed on the negative branch inside the inverter. The inverter may include a controller. The controller may obtain a current value of any negative branch based on a current value obtained by each current sensor, and the controller may determine, in response to that the current value of the any negative branch is greater than a preset current threshold, that the any negative branch is short-circuited. The controller can generate an alarm prompt for one or more negative branches that are short-circuited, facilitating repair or replacement of the faulty negative branch, so that the faulty negative branch is located quickly and accurately, to avoid overcurrent caused because a faulty photovoltaic string cable is short-circuited to the ground inside the inverter. This ensures reliable functioning of the inverter.

## Claims

1. A power generation system, wherein the power generation system comprises a plurality of photovoltaic modules, an inverter, and a transformer, the inverter comprises a plurality of photovoltaic interfaces, a direct current conversion circuit, an inverter circuit, and a controller, each photovoltaic interface is configured to be connected to one photovoltaic module, the inverter circuit comprises at least one bridge arm and a bus capacitor, a positive output end and a negative output end of the direct current conversion circuit are respectively connected to two ends of the bus capacitor, a bridge arm middle point of the at least one bridge arm is connected to a primary-side winding of the transformer as an output end of the inverter, and is grounded through the transformer, the bridge arm comprises at least one lower bridge arm switching transistor, and a direction of a current flowing through the at least one lower bridge arm switching transistor is from the bus capacitor to the bridge arm middle point when the at least one lower bridge arm switching transistor is turned off;
the plurality of photovoltaic interfaces comprise positive interfaces and negative interfaces, the positive interfaces of the plurality of photovoltaic interfaces are connected to a positive input end of the direct current conversion circuit after being converged through a plurality of positive branches, the negative interfaces of the plurality of photovoltaic interfaces are connected to a negative input end of the direct current conversion circuit after being converged through a plurality of negative branches, and current sensors are disposed on some or all of the plurality of negative branches; and
the controller is configured to: locate, in response to that a current value on a current loop formed by any negative branch of the plurality of negative branches and the direct current conversion circuit, the lower bridge arm switching transistor in the at least one bridge arm, and the transformer is greater than a preset current threshold, that a short-circuit to ground fault occurs on the any negative branch, and send short-circuit fault information that comprises a location of the any negative branch.

2. The power generation system according to claim 1, wherein the plurality of negative branches are sequentially connected to a negative bus, and connected to the negative input end of the direct current conversion circuit through the negative bus;
the plurality of negative branches comprise a first negative branch, one branch current sensor is disposed on the first negative branch, the branch current sensor is located between a negative interface corresponding to the first negative branch and the negative bus, and the branch current sensor is configured to measure current information of the first negative branch, and upload the current information of the first negative branch to the controller; and
the plurality of negative branches comprise a second negative branch, a combination current sensor is disposed at a connection end between the second negative branch and the negative bus, the second negative branch is located on the negative bus, and the combination current sensor is configured to measure current information of the connection end between the second negative branch and the negative bus, and upload the current information of the connection end between the second negative branch and the negative bus to the controller

3. The power generation system according to claim 2, wherein the controller is configured to: obtain a current value of the first negative branch based on the current information that is obtained by the branch current sensor disposed on the first negative branch; and
obtain, based on the current information that is obtained by the combination current sensor corresponding to the second negative branch, a sum of a current value of the second negative branch and current values of negative branches before the second negative branch, and subtract a sum of the current values of the negative branches before the second negative branch from the sum of the current values to obtain the current value of the second negative branch.

4. The power generation system according to claim 3, wherein the inverter comprises N photovoltaic interfaces, N negative branches corresponding to the N photovoltaic interfaces comprise N-1 first negative branches and one second negative branch, and one combination current sensor is disposed between the negative input end of the direct current conversion circuit and a connection end between the second negative branch and the negative bus; and
the controller is configured to: obtain current values of the N-1 first negative branches based on current information obtained by branch current sensors disposed on the N-1 first negative branches; and
obtain a sum of current values of the N negative branches based on current information obtained by the combination current sensor, and subtract a sum of the current values of the N-1 first negative branches from the sum of the current values of the N negative branches to obtain a current value of the second negative branch.

5. The power generation system according to claim 1, wherein one branch current sensor is disposed on each of the plurality of negative branches; and
the branch current sensor is configured to: measure current information of a branch on which the branch current sensor is located, and upload the current information of the branch to the controller.

6. The power generation system according to claim 1, wherein the inverter comprises a first photovoltaic interface and a second photovoltaic interface, one branch current difference sensor is disposed on a negative branch corresponding to a negative interface of the first photovoltaic interface, a negative branch corresponding to a negative interface of the second photovoltaic interface is connected, through the branch current difference sensor, to the negative branch corresponding to the negative interface of the first photovoltaic interface, and a connection end between the negative branches corresponding to the negative interfaces of the first photovoltaic interface and the second photovoltaic interface is connected to the negative input end of the direct current conversion circuit through one combination current sensor; and
the branch current difference sensor is configured to: measure a difference between currents of the negative branches corresponding to the negative interfaces of the first photovoltaic interface and the second photovoltaic interface, and upload the difference between the currents to the controller, and the combination current sensor is configured to measure: a sum of current values of the negative branches corresponding to the negative interfaces of the first photovoltaic interface and the second photovoltaic interface, and upload the sum of the current values to the controller

7. The power generation system according to any one of claims 1 to 6, wherein the inverter circuit comprises a positive bus capacitor and a negative bus capacitor that are connected in series, the bridge arm comprises one lower bridge arm switching transistor, one end of the lower bridge arm switching transistor is connected to a positive electrode of one diode and connected to the negative bus capacitor, and the other end of the lower bridge arm switching transistor is connected to a negative electrode of the diode and connected to the bridge arm middle point.

8. The power generation system according to any one of claims 1 to 6, wherein the inverter circuit comprises a positive bus capacitor and a negative bus capacitor that are connected in series, the bridge arm comprises a first lower bridge arm switching transistor and a second lower bridge arm switching transistor that are connected in series, one end of the first lower bridge arm switching transistor is connected to a positive electrode of a first diode and connected to the negative bus capacitor, the other end of the first lower bridge arm switching transistor is connected to a negative electrode of the first diode, one end of the second lower bridge arm switching transistor is connected to a positive electrode of a second diode, and the other end of the second lower bridge arm switching transistor is connected to a negative electrode of the second diode and connected to the bridge arm middle point, and
wherein the inverter comprises a voltage detection circuit, and the voltage detection circuit is configured to obtain a negative photovoltaic voltage value at the negative input end of the direct current conversion circuit; and
the controller is configured to: locate, in response to that the negative photovoltaic voltage value is greater than a voltage threshold and a current value of the any negative branch is greater than the preset current threshold, that the short-circuit fault occurs on the any negative branch, and send the short-circuit fault information that comprises the location of the any negative branch.

9. The power generation system according to any one of claims 1 to 8, wherein the inverter comprises a leakage current detection circuit, and the leakage current detection circuit is configured to obtain a difference between currents at any two phases of output ends of three phases of output ends of the inverter circuit; and
the controller is configured to, locate, in response to that the difference between the currents of the any two phases of output ends of the three phases of output ends of the inverter circuit is greater than a specified threshold and a current value of the any negative branch is greater than the preset current threshold, that the short-circuit fault occurs on the any negative branch, and send the short-circuit fault information that comprises the location of the any negative branch.

10. The power generation system according to any one of claims 1 to 8, wherein the inverter comprises an inverter output sampling circuit, and the inverter output sampling circuit is configured to obtain currents at three phases of output ends of the inverter circuit; and
the controller is configured to: locate, in response to that a difference between currents at any two phases of output ends of the three phases of output ends of the inverter circuit is greater than a specified threshold and a current value of the any negative branch is greater than the preset current threshold, that the short-circuit fault occurs on the any negative branch, and send the short-circuit fault information that comprises the location of the any negative branch.

11. An inverter, wherein the inverter comprises a plurality of photovoltaic interfaces, a direct current conversion circuit, an inverter circuit, and a controller, the inverter circuit comprises at least one bridge arm and a bus capacitor, a positive output end and a negative output end of the direct current conversion circuit are respectively connected to two ends of the bus capacitor, a bridge arm middle point of the at least one bridge arm is connected to a primary-side winding of a transformer as an output end of the inverter, and is grounded through the transformer, the bridge arm comprises at least one lower bridge arm switching transistor, and a direction of a current flowing through the at least one lower bridge arm switching transistor is from the bus capacitor to the bridge arm middle point when the at least one lower bridge arm switching transistor is turned off;
the plurality of photovoltaic interfaces comprise positive interfaces and negative interfaces, the positive interfaces of the plurality of photovoltaic interfaces are connected to a positive input end of the direct current conversion circuit after being converged through a plurality of positive branches, the negative interfaces of the plurality of photovoltaic interfaces are connected to a negative input end of the direct current conversion circuit after being converged through a plurality of negative branches, and current sensors are disposed on some or all of the plurality of negative branches; and
the controller is configured to: locate, in response to that a current value on a current loop formed by any negative branch of the plurality of negative branches and the direct current conversion circuit, the lower bridge arm switching transistor in the at least one bridge arm, and the transformer is greater than a preset current threshold, that a short-circuit to ground fault occurs on the any negative branch, and send short-circuit fault information that comprises a location of the any negative branch.

12. The inverter according to claim 11, wherein the plurality of negative branches are sequentially connected to a negative bus, and connected to the negative input end of the direct current conversion circuit through the negative bus;
the plurality of negative branches comprise a first negative branch, one branch current sensor is disposed on the first negative branch, the branch current sensor is located between a negative interface corresponding to the first negative branch and the negative bus, and the branch current sensor is configured to measure current information of the first negative branch, and upload the current information of the first negative branch to the controller; and
the plurality of negative branches comprise a second negative branch, a combination current sensor is disposed at a connection end between the second negative branch and the negative bus, the second negative branch is located on the negative bus, and the combination current sensor is configured to measure current information of the connection end between the second negative branch and the negative bus, and upload the current information of the connection end between the second negative branch and the negative bus to the controller, and
wherein the controller is configured to: obtain a current value of the first negative branch based on the current information that is obtained by the branch current sensor disposed on the first negative branch; and
obtain, based on the current information that is obtained by the combination current sensor corresponding to the second negative branch, a sum of a current value of the second negative branch and current values of negative branches before the second negative branch, and subtract a sum of the current values of the negative branches before the second negative branch from the sum of the current values to obtain the current value of the second negative branch.

13. The inverter according to claim 12, wherein the inverter comprises N photovoltaic interfaces, N negative branches corresponding to the N photovoltaic interfaces comprise N-1 first negative branches and one second negative branch, and one combination current sensor is disposed between the negative input end of the direct current conversion circuit and a connection end between the second negative branch and the negative bus; and
the controller is configured to: obtain current values of the N-1 first negative branches based on current information obtained by branch current sensors disposed on the N-1 first negative branches; and
obtain a sum of current values of the N negative branches based on current information obtained by the combination current sensor, and subtract a sum of the current values of the N-1 first negative branches from the sum of the current values of the N negative branches to obtain a current value of the second negative branch.

14. The inverter according to claim 11, wherein the inverter comprises a first photovoltaic interface and a second photovoltaic interface, one branch current difference sensor is disposed on a negative branch corresponding to a negative interface of the first photovoltaic interface, a negative branch corresponding to a negative interface of the second photovoltaic interface is connected, through the branch current difference sensor, to the negative branch corresponding to the negative interface of the first photovoltaic interface, and a connection end between the negative branches corresponding to the negative interfaces of the first photovoltaic interface and the second photovoltaic interface is connected to the negative input end of the direct current conversion circuit through one combination current sensor; and
the branch current difference sensor is configured to: measure a difference between currents of the negative branches corresponding to the negative interfaces of the first photovoltaic interface and the second photovoltaic interface, and upload the difference between the currents to the controller, and the combination current sensor is configured to measure: a sum of current values of the negative branches corresponding to the negative interfaces of the first photovoltaic interface and the second photovoltaic interface, and upload the sum of the current values to the controller

15. A short-circuit detection method for a negative branch of an inverter, wherein the method comprises:
in response to that a current value of any negative branch of a plurality of negative branches is greater than a preset current threshold, locating that a short-circuit fault occurs on the any negative branch, and sending short-circuit fault information that comprises a location of the any negative branch, wherein positive interfaces of a plurality of photovoltaic interfaces in the inverter are connected to a positive input end of a direct current conversion circuit after being converged through a plurality of positive branches, negative interfaces of the plurality of photovoltaic interfaces are connected to a negative input end of the direct current conversion circuit after being converged through the plurality of negative branches, and current sensors are disposed on some or all of the plurality of negative branches.
